# EUROPEAN PATENT APPLICATION

(11) **EP 4 149 217 A1**
(43) Date of publication of application: **15.03.2023**
(21) Application number: 21799543.0
(22) Date of filing: 27.04.2021
(51) Int. Cl.: H05K 1/11, H05K 3/40

(54) **INTERPOSER STRUCTURE AND ELECTRONIC DEVICE COMPRISING SAME**

(30) Priority: 08.05.2020 KR 20200055356; 04.11.2020 KR 20200146327
(71) Applicant: Samsung Electronics Co., Ltd., Gyeonggi-do 16677 (KR)
(72) Inventor: HA, Sangwon, Suwon-si Gyeonggi-do 16677 (KR); KIM, Jichul, Suwon-si Gyeonggi-do 16677 (KR); PARK, Jinyong, Suwon-si Gyeonggi-do 16677 (KR); CHUNG, Yeonkyung, Suwon-si Gyeonggi-do 16677 (KR)
(74) Representative: Gulde & Partner
(86) International application number: PCT/KR2021/005331
(87) International publication number: WO 2021/225323

(57) **Abstract**

The present disclosure relates to an interposer structure and an electronic device including the same, and the interposer structure according to an embodiment of the present disclosure may include an insulation layer including at least one through hole, a first solder resist layer positioned on at least one region of a top surface of the insulation layer, and including at least one first opening formed in a region corresponding to the at least one through hole, a second solder resist layer positioned on at least one region of a bottom surface of the insulation layer, and including at least one second opening formed in a region corresponding to the at least one through hole, at least one conductive via positioned in the at least one through hole, the at least one conductive via including a first protruding portion which protrudes in a direction of the at least one first opening and a second protruding portion which protrudes in a direction of the at least one second opening, a first presolder disposed at an upper end of the first protruding portion of the at least one conductive via and a second presolder disposed at a lower end of the second protruding portion of the at least one conductive via.

## Description

### [Technical Field]

Various embodiments of the present disclosure relate to an interposer structure and an electronic device including the same.

### [Background Art]

While a size of an electronic device gradually gets smaller, functions of the electronic device are diversified, and accordingly it has become important to obtain a space for arranging electronic components (e.g., a processor, a communication circuit and/or a memory) for performing various functions of the electronic devices with high density.

Recently, electronic devices which form a stack structure of a plurality of printed circuit boards using an interposer to acquire the space for arranging the electronic components are increasing. For example, the electronic device may acquire the space for arranging the electronic components, by stacking the plurality of the printed circuit boards, and arranging the interposer including at least one via for electrically connecting the printed circuit boards between the stacked printed circuit boards.

### [Disclosure of Invention]

### [Technical Problem]

To stack a plurality of printed circuit boards using an interposer, it is necessary to securely fix the plurality of the printed circuit boards onto and/or below the interposer.

Electronic devices adopting a structure which, to securely fix the plurality of the printed circuit boards, forms a land at a top end and/or a bottom end of at least one via passing through the interposer, and then secures (or "soldering") the plurality of the printed circuit boards to the interposer using a presolder received on the land are gradually increasing.

However, in the above-described structure, it is necessary to separate a pitch between the vias over a designated pitch to acquire the space for forming the land at the top end and/or the bottom end of the at least one via. It is required to separate spacings between electronic components to correspond to the pitch between the vias to maintain electronic connections between the electronic components, and it may be difficult to densely mount the electronic components onto the plurality of the printed circuit boards in the electronic device adopting the above structure.

In addition, it is general to manufacture a conventional interposer in a process which primarily plates an inside of a hole (or "via hole") formed in the printed circuit board (PCB), forms a via by filling the inside of the plated hole with a dielectric material (e.g., photo imageable solder resist (PSR) mask ink)), and forms a land and a side plated portion by secondarily plating a top surface, a bottom surface and/or a side surface of the PCB. That is, as the conventional interposer is manufactured through the process which additionally plates the PCB to form the land in addition to plating the PCB to form the via, the manufacturing process is lengthened, a manufacturing cost increases, and as a result, reliability of the manufactured product may be lowered, or defects may occur in the manufacturing process.

The present disclosure is to provide an interposer structure and an electronic device including the same for enabling high-density mounting of electronic components, and reducing the manufacturing cost and the manufacturing processor, by applying a structure (or "landless structure") which does not form the land at the top end and/or the bottom end the PCB.

Technical problems to achieve in this document are not limited to the above-mentioned technical problems, and other technical problems which are not mentioned may be clearly understood by those skilled in the art of the present invention through the following descriptions.

### [Solution to Problem]

An interposer structure according to an embodiment of the present disclosure may include an insulation layer including at least one through hole, a first solder resist layer positioned on at least one region of a top surface of the insulation layer, and including at least one first opening formed in a region corresponding to the at least one through hole, a second solder resist layer positioned on at least one region of a bottom surface of the insulation layer, and including at least one second opening formed in a region corresponding to the at least one through hole, at least one conductive via positioned in the at least one through hole, the at least one conductive via including a first protruding portion which protrudes in a direction of the at least one first opening and a second protruding portion which protrudes in a direction of the at least one second opening, a first presolder disposed at an upper end of the first protruding portion of the at least one conductive via and a second presolder disposed at a lower end of the second protruding portion of the at least one conductive via.

An interposer structure according to another embodiment of the present disclosure may include an insulation layer including at least one through hole and a slot, a first solder resist layer positioned on at least one region of a top surface of the insulation layer, and including at least one first opening formed in a region corresponding to the at least one through hole and at least one second opening formed in a region corresponding to the at least one region of the slot, a second solder resist layer positioned on at least one region of a bottom surface of the insulation layer, and including at least one third opening formed in a region corresponding to the at least one through hole and at least one fourth opening formed in a region corresponding to the at least one region of the slot, a first conductive via positioned in the at least one through hole and formed to have a first height, the at least one conductive via including a first protruding portion formed to protrude toward the at least one third opening and a second protruding portion formed to protrude toward the at least one fourth opening, a second conductive via positioned in the slot and formed to have a second height lower than the first height, a first presolder disposed at a top of the first conductive via and the second conductive via and a second presolder disposed at a bottom of the first conductive via and the second conductive via.

An interposer structure according to an embodiment of the present disclosure may include a first printed circuit board, a second printed circuit board separated from the first printed circuit board, and facing at least one surface of the first printed circuit board, at least one electronic component disposed on the first printed circuit board or the second printed circuit board and an interposer positioned between the first printed circuit board and the second printed circuit board, and disposed to surround a space between the first printed circuit board and the second printed circuit board, the interposer including a first surface facing the first printed circuit board and a second surface facing the second printed circuit board, an insulation layer including at least one through hole formed by penetrating the first surface and the second surface, a first solder resist layer disposed in at least one region of the first surface of the insulation layer, and including a first opening formed in a region corresponding to the at least one through hole, a second solder resist layer disposed in at least one region of the second surface of the insulation layer, and including a second opening formed in a region corresponding to the at least one through hole and a first conductive via positioned inside the at least one through hole, and including a first protruding portion formed by protruding from the first surface of the insulation layer to the first solder resist layer and a second protruding portion formed by protruding from the second surface of the insulation layer to the second solder resist layer, and the first printed circuit board may be electrically connected with the second printed circuit board through the first conductive via.

### [Advantageous Effects of Invention]

An interposer structure according to various embodiments of the present disclosure, which does not form a land, may reduce a pitch between conductive vias, and thus densely mount electronic components on a printed circuit board disposed on and/or below the interposer structure.

An interposer structure according to various embodiments of the present disclosure may omit a plating process for generating a land, thus reducing a manufacturing cost.

An interposer structure according to various embodiments of the present disclosure may simplify manufacturing processing (e.g., omit side plating processing), thus improve manufacturing efficiency.

### [Brief Description of Drawings]

FIG. 1 is a block diagram of an electronic device in a network environment according to various embodiments.
FIG. 2 is a perspective view illustrating a front surface of an electronic device according to an embodiment.
FIG. 3 is a perspective view illustrating a rear surface of an electronic device of FIG. 2.
FIG. 4 is an exploded perspective view of an electronic device according to an embodiment.
FIG. 5 is an exploded view and an assembled view of a printed circuit board structure according to an embodiment.
FIG. 6 is an enlarged view of an interposer structure and a region A of the interposer structure according to an embodiment.
FIG. 7 is a cross-sectional view of an interposer structure of FIG. 6 taken along an I-I' direction.
FIG. 8 is a flowchart illustrating manufacturing operations of an interposer structure according to an embodiment.
FIG. 9A is a diagram for explaining an operation of forming at least one through hole in a printed circuit board, according to an embodiment.
FIG. 9B is a diagram for explaining an operation of filling an inside of at least one through hole with a conductive material, and planarizing a printed circuit board, according to an embodiment.
FIG. 9C is a diagram for explaining an operation of etching a printed circuit board, according to an embodiment.
FIG. 9D is a diagram for explaining an operation of forming a solder resist layer on a top surface and/or a bottom surface of a printed circuit board, according to an embodiment.
FIG. 9E is a diagram for explaining an operation of forming a presolder, according to an embodiment.
FIG. 10 is an enlarged view of an interposer structure and a region B of the interposer structure according to another embodiment.
FIG. 11A is a cross-sectional view of an interposer structure of FIG. 10 taken along a I-I' direction.
FIG. 11B is a cross-sectional view of an interposer structure of FIG. 10 taken along a II-II' direction.
FIG. 11C is a cross-sectional view of an interposer structure of FIG. 10 taken along a III-III' direction.
FIG. 11D is a diagram illustrating that a solder resist layer and/or a presolder are removed from an interposer structure of FIG. 10.
FIG. 12 is a flowchart illustrating manufacturing operations of an interposer structure according to another embodiment.
FIG. 13A is a diagram for explaining an operation of forming at least one through hole and/or a slot in a printed circuit board, according to an embodiment.
FIG. 13B is a diagram for explaining an operation of filling an inside of at least one through hole and/or a slot with a conductive material, and planarizing a printed circuit board, according to an embodiment.
FIG. 13C is a diagram for explaining an operation of etching a printed circuit board, according to an embodiment.
FIG. 13D is a diagram for explaining an operation of forming a solder resist layer on a top surface and/or a bottom surface of a printed circuit board, according to an embodiment.
FIG. 13E is a diagram for explaining an operation of forming a presolder, according to an embodiment.
FIG. 14 is an enlarged view of an interposer structure and a region C of the interposer structure according yet to another embodiment.
FIG. 15A is a cross-sectional view of an interposer structure of FIG. 14 taken along a I-I' direction, according to an embodiment.
FIG. 15B is a cross-sectional view of an interposer structure of FIG. 14 taken along a I-I' direction, according to another embodiment.
FIG. 16 is a flowchart illustrating manufacturing operations of an interposer structure according to yet another embodiment.
FIG. 17A is a diagram for explaining an operation of forming at least one through hole in a printed circuit board, according to an embodiment.
FIG. 17B is a diagram for explaining an operation of plating an inside of at least one through hole and/or a side surface of an insulation layer, according to an embodiment.
FIG. 17C is a diagram for explaining an operation of filling an inside of at least one through hole with a conductive material, and planarizing a printed circuit board, according to an embodiment.
FIG. 17D is a diagram for explaining an operation of etching a printed circuit board, according to an embodiment.
FIG. 17E is a diagram for explaining an operation of forming a solder resist layer on a top surface and/or a bottom surface of a printed circuit board, according to an embodiment.
FIG. 17F is a diagram for explaining an operation of forming a presolder, according to an embodiment.

### [Best Mode for Carrying out the Invention]

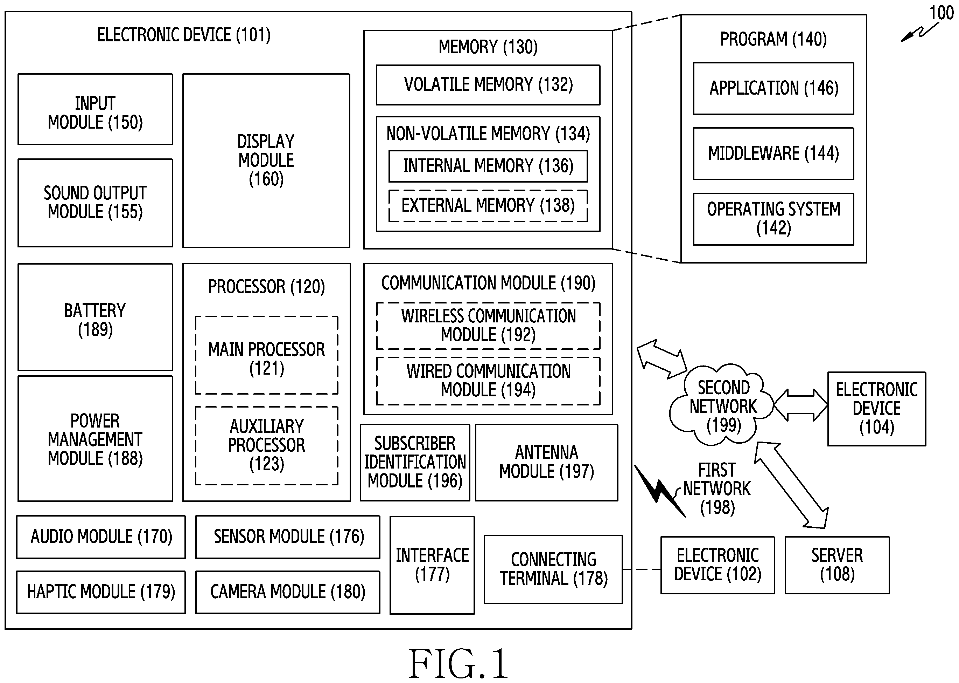

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adj acent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

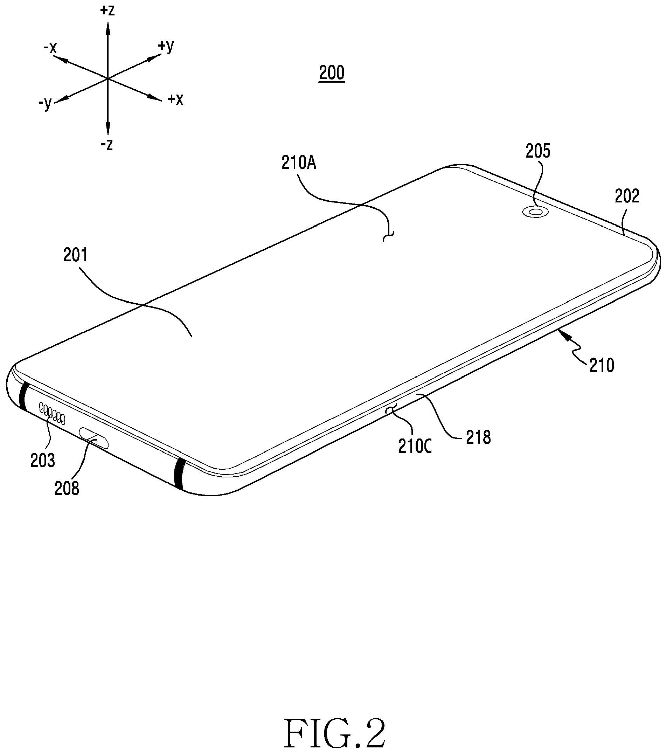

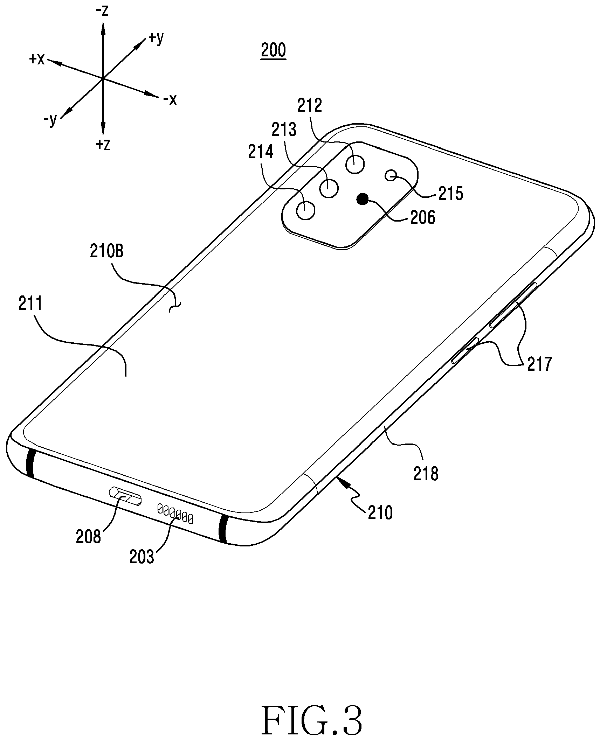

FIG. 2 is a perspective view illustrating a front surface of an electronic device according to an embodiment, and FIG. 3 is a perspective view illustrating a rear surface of the electronic device of FIG. 2.

Referring to FIG. 2 and FIG. 3, an electronic device 200 according to an embodiment may include a housing 210 which includes a first surface (or a "front surface") 210A, a second surface (or a "rear surface") 210B, and a side surface (or a "side wall") 210C surrounding a space between the first surface 210A and the second surface 210B. In another embodiment (not shown), the housing 210 may indicate a structure which forms a part of the first surface 210A, the second surface 210B, and the side surfaces 210C of FIG. 2 and FIG. 3.

According to an embodiment, the first face 210A may be formed at least in part by a substantially transparent front plate 202 (e.g., a glass plate including various coating layers, or a polymer plate). According to an embodiment, the front plate 202 may include a curved portion bending and seamlessly extending from the first surface210A to a rear plate 211 at least in a side edge portion.

According to an embodiment, the second surface 210B may be formed by the rear plate 211 which is substantially opaque. The rear plate 211 may be formed of, for example, coated or colored glass, ceramic, a polymer, a metal (e.g., aluminum, stainless steel (STS), or magnesium), or a combination of two or more of these materials. According to an embodiment, the rear plate 111 may include a curved portion bending and seamlessly extending from the second surface 210B toward the front plate 202 at least in a side edge portion.

According to an embodiment, the side surface 210C may be coupled with the front plate 202 and the rear plate 211, and may be formed by a side member (or a "bracket") 218 including a metal and/or a polymer. In some embodiment, the rear plate 211 and the side member 218 may be integrated and may include the same material (e.g., a metallic material such as aluminum).

According to an embodiment, the electronic device 200 may include at least one or more of a display 201 (e.g., the display module 160 of FIG. 1), an audio module 203 (e.g., the audio module 170 of FIG. 1), a sensor module (not shown) (e.g., the sensor module 176 of FIG. 1), camera modules 205, 212, 213, 214, and 215 (e.g., the camera module 180 of FIG. 1), a flash 206, a key input device 217 (e.g., the input module 150 of FIG. 1) and a connector hole 208 (e.g., the connection terminal 178 of FIG. 1). In some embodiment, the electronic device 200 may omit at least one (e.g., the key input device 217) of the components or may further include other component. For example, the electronic device 200 may include a sensor mode which is not shown. For example, a sensor such as a proximity sensor or an illumination sensor may be integrated with the display 201, or may be disposed adjacent to the display 201 in a region provided by the front plate 202. In some embodiment, the electronic device 200 may further include a light emitting element, and the light emitting element may be disposed adjacent to the display 201 in the region provided by the front plate 202. The light emitting element, for example, may provide state information of the electronic device 200 in the form of light. In another embodiment, the light emitting element, for example, may provide a light source interoperating with the camera module 205. The light emitting element may include, for example, a light emitting diode (LED), an infrared (IR) LED, and a xenon lamp.

The display 201 may be viewed to outside of the electronic device 200 through, for example, a substantial portion of the front plate 202. In some embodiment, the edge of the display 201 may be formed to be substantially the same as an adjacent outer shape (e.g., a curved surface) of the front plate 202. In another embodiment (not shown), to expand an area for exposing the display 201, a spacing between an outer edge of the display 201 and an outer edge of the front plate 202 may be substantially the same. In another embodiment (not shown), a recess or an opening may be formed in a part of a screen display region of the display 201, and other electronic component aligned with the recess or the opening, for example, the camera module 205 (or a camera device), a proximity sensor or an illuminance sensor not shown may be included.

According to an embodiment, at least one camera module 205, 212, 213, 214, and 215 may be disposed in a lower direction (e.g., the -z axis direction) of the display 201. For example, the first camera module 205 may be disposed on at least a partial region of the display 201 corresponding to a camera field of view (FOV). As the first camera device 205 is disposed in at least a partial region of the display 201 corresponding to the FOV, the position of the first camera module 205 may not be visually identified (or exposed). According to an embodiment, when the display 201 is viewed from the first surface 210A, the first camera module 205 may be disposed in the portion corresponding to the FOV, which is at least a part of the display 201, to acquire an image of an external subject without being visually exposed to the outside. For example, the first camera device 205 may be an under display camera (UDC).

In an embodiment, the electronic device 200 may include a display (not shown) which is disposed to be slidable and provides a screen (e.g., a display region). For example, the display region of the electronic device 200 may be a region which is visually exposed to output an image. In one example, the electronic device 200 may adjust the display region according to movement of a sliding plate (not shown) or movement of the display. For example, the electronic device 200 may include a rollable electronic device which operates to slide at least a part (e.g., the housing 210) of the electronic device 200 at least in part, thus selectively expanding the display region. The above-described display may be referred to as, for example, a slide-out display or an expandable display.

In another embodiment (not shown), a rear surface (e.g., the second surface 210B) of the screen display region of the display 201 may include at least one or more of the camera modules (e.g., 212, 213, 214, 215), a fingerprint sensor, and the flash 206. In yet another embodiment (not shown), the display 201 may be coupled with or disposed close to a touch detection circuit, a pressure sensor for measuring a touch intensity (pressure), and/or a digitizer for detecting a magnetic field type stylus pen.

In an embodiment, the audio module 203 may include a microphone hole and/or a speaker hole. A microphone for acquiring an external sound may be disposed in the microphone hole, and a plurality of microphones may be disposed to detect a direction of the sound in some embodiment. In some embodiment, the speaker hole and the microphone hole may be implemented as a single hole 203, or the speaker may be included without the speaker hole (e.g., a piezo speaker). The speaker hole may include an external speaker hole and a call receiving hole.

In an embodiment, the electronic device 200, which includes the sensor module (not shown), may generate an electrical signal or a data value corresponding to an internal operating state, or an external environmental state. The sensor module may further include, for example, a proximity sensor disposed in the first surface 210A of the housing 210, a fingerprint sensor integrated with or disposed close to the display 201, and/or a biometric sensor (e.g., a heart rate monitor (HRM) sensor) disposed on the second surface 210B of the housing 210. The electronic device 200 may further include the sensor module which is not shown, for example, at least one of a gesture sensor, a gyro sensor, a barometric pressure sensor, a magnetic sensor, an acceleration sensor, a grip sensor, a color sensor, an IR sensor, a biometric sensor, a temperature sensor, a humidity sensor, or an illuminance sensor.

In an embodiment, the camera modules 205, 212, 213, 214, and 215 may include the first camera module 205 disposed in the first surface 210A of the electronic device 200, and the second camera modules 212, 213, 214, and 215 disposed in the second surface 210B of the electronic device 200. The aforementioned camera modules 205, 212, 213, 214, and 215 may include one or more lenses, an image sensor, and/or an image signal processor. In another embodiment, the flash 206 may include, for example, a light emitting diode or a xenon lamp. In some embodiment, two or more lenses (an infrared camera, wide-angle and telephoto lenses) and image sensors may be disposed in one surface of the electronic device 200.

In an embodiment, the key input device 217 may be disposed on the side surface 210C of the housing 210. In another embodiment, the electronic device 200 may not include part or whole of the above-mentioned key input device 217 and the key input device 217 not included may be implemented on the display 201 in a different form such as a soft key. In some embodiment, the key input device may include at least a part of the fingerprint sensor disposed in the second surface 210B of the housing 210.

In an embodiment, the connector hole 208 may accommodate a connector for transmitting and receiving power and/or data to and from an external electronic device, and/or a connector for transmitting and receiving an audio signal to and from an external electronic device. For example, the connector hole 208 may include a universal serial bus (USB) connector or an earphone jack. In an embodiment, the USB connector and the earphone jack may be implemented as a single hole (e.g., 208 of FIG. 2, FIG. 3), and according to another embodiment (not shown), the electronic device 200 may transmit and receive power and/or data, or transmit and receive an audio signal to and from the external electronic device without a separate connector hole.

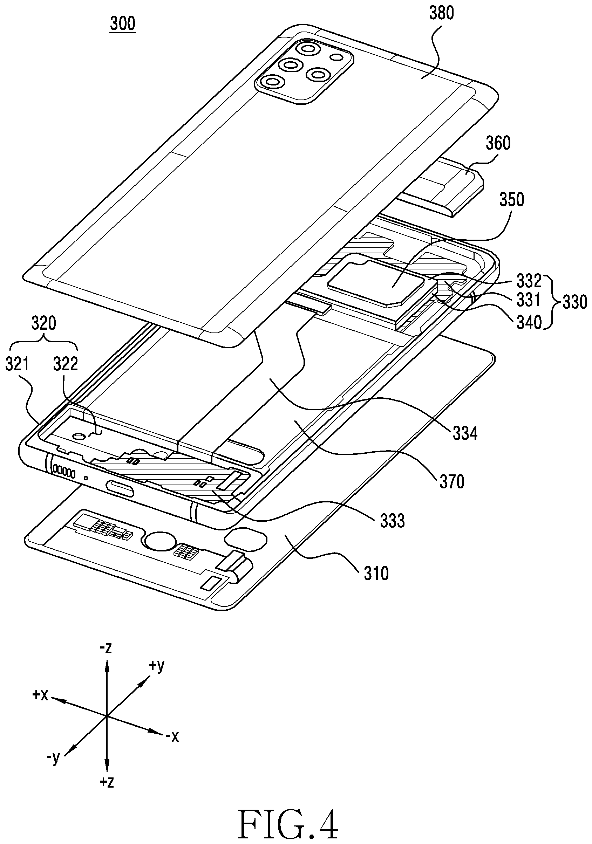

FIG. 4 is an exploded perspective view of an electronic device according to an embodiment.

Referring to FIG. 4, an electronic device 300 (e.g., the electronic device 200 of FIG. 2, FIG. 3) according to an embodiment may include a front plate (not shown) (e.g., the front plate 202 of FIG. 2), a display 310 (e.g., the display 201 of FIG. 2), a side member 320 (e.g., the side member 218 of FIG. 2, FIG. 3), a printed circuit board structure 330 (e.g., a printed circuit board (PCB), a flexible PCB (FPCB) or a rigid-flexible PCB (RFPCB)), a shielding structure 350, a rear case 360, a battery 370 and/or a rear plate 380. According to another embodiment (not shown), at least one component (e.g., the shielding structure 350, the rear case 360) of the above-described components of the electronic device 300 may be omitted, or other component may be added.

According to an embodiment, the side member 320 may be interposed between the display 310 and the rear plate 380, and may include a metal frame structure 321 and/or a support member 322.

In an example, the metal frame structure 321 of the side member 320 may be formed of a conductive material (e.g., metal), to form a side surface (e.g., the side surface 210C of FIG. 2) of the electronic device 300. For example, the metal frame structure 321 may include at least one conductive portion and/or at least one nonconductive portion for insulating the at least one conductive portion. The at least one conductive portion of the metal frame structure 321 may serve as an antenna radiator which transmits and/or receives a radio frequency (RF) signal of a designated frequency band.

According to an embodiment, an antenna structure may be formed by a part, or a combination of the side member 320. For example, an antenna (or "antenna structure") (not shown) may be disposed in a part of the side member 320, or at least a part of a space generated by a combination thereof. In an example, the antenna may include at least one radiation conductor (or "emitter"), and may communicate a radio signal (or "RF signal") by receiving feeding from a communication module (or "wireless communication circuit") (e.g., the communication module 192 of FIG. 1) disposed on the printed circuit board structure 330. The communication in the present disclosure may indicate at least one of radio signal transmission, radio signal reception and/or radio signal transmission and reception, and may be used hereinafter with the same meaning.

According to an embodiment, the antenna may be an antenna configured to transmit and/or receive a radio signal in a frequency band over several tens of GHz. For example, the antenna may be an antenna for millimeter wave (mmWave) communication. According to another embodiment, the antenna may include a plurality of antennas for communicating in a plurality of different frequency bands. For example, the antenna may include a first antenna for communicating in a first frequency band (e.g., about 10 GHz) and a second antenna for communicating in a second frequency band (e.g., about 18 GHz).

In another example, the support member 322 of the side member 320 may be formed of a metal material and/or a nonmetal (e.g., polymer) material, to provide a space (or "mounting space") for arranging electronic components in the electronic device 300. For example, the display 310 may be disposed on one surface (e.g., one surface of the +z direction of FIG. 4) of the support member 322, and the printed circuit board structure 330 may be disposed on the other surface (e.g., one surface of the -z direction of FIG. 4) of the support member 322. According to an embodiment, the support member 322 may be connected with the metal frame structure 321, or may be integrally formed with the metal frame structure 321.

According to an embodiment, the printed circuit board structure 330 may be disposed on at least one region of the support member 322. In the present disclosure, the printed circuit board structure 330 may indicate a structure in which a plurality of printed circuit boards 331 and 332 is stacked. For example, the printed circuit board structure 330 may include the first printed circuit board 331, the second printed circuit board 332, and/or an interposer 340. As another example, the printed circuit board structure 330 may be a structure in which the interposer 340 and the second printed circuit board 332 are stacked in order based on the first printed circuit board 331.

In an embodiment, the first printed circuit board 331 may be disposed on at least one region of the support member 322. In another embodiment, the second printed circuit board 332 may be spaced apart from the first printed circuit board 331, and positioned on the -z direction based on the first printed circuit board 331. For example, the second printed circuit board 332 may be disposed to face one surface toward the -z direction of the first printed circuit board 331. According to an embodiment, the first printed circuit board 331 and/or the second printed circuit board 332 may be a PCB formed of a material (e.g., FR4) having a non-bending property, or a flexible FPCB having a bendable property (or "flexible property").

In an embodiment, the interposer 340 may be interposed between the first printed circuit board 331 and the second printed circuit board 332, to support the second printed circuit board 332 positioned on the -z direction of the first printed circuit board 331. For example, the interposer 340 may be disposed to surround a space between the first printed circuit board 331 and the second printed circuit board 332. In one example, the interposer 340 may include a printed circuit board (not shown) including at least one side wall and/or at least one conductive via (not shown) passing through at least one region of the printed circuit board. In another example, the first printed circuit board 331 and the second printed circuit board 332 may be electrically connected through the at least one conductive via of the interposer 340.

According to an embodiment, a plurality of electronic components may be disposed on the first printed circuit board 331 and/or the second printed circuit board 332 constituting the printed circuit board structure 330. For example, the first printed circuit board 331 and/or the second printed circuit board 332 may include a processor (e.g., the processor 120 of FIG. 1), a memory (e.g., the memory 130 of FIG. 1), and/or an interface (e.g., the interface 177 of FIG. 1). The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high definition multimedia interface (HDMI), a USB interface, a secure digital (SD) card interface, and/or an audio interface. The interface may, for example, electrically or physically connect the electronic device 300 to an external electronic device, and may include a USB connector, an SD card/MMC connector, or an audio connector. In an example, the plurality of the electronic components disposed on the first printed circuit board 331 and the plurality of the electronic components disposed on the second printed circuit board 332 may be electrically and/or operatively connected through the interposer 340.

According to an embodiment, the first printed circuit board 331 and/or the second printed circuit board 332 of the printed circuit board structure 330 may be electrically connected to a third printed circuit board 333 disposed away from the printed circuit board structure 330. For example, the first printed circuit board 331 and/or the second printed circuit board 332 of the printed circuit board structure 330 may be formed in one region (e.g., a region of the +y direction of FIG. 4) of the support member 322, and the third printed circuit board 333 may be disposed in another region (e.g., a region of the -y direction of FIG. 4) of the support member 322 spaced apart from the first printed circuit board 331 and/or the second printed circuit board 332. In one example, the first printed circuit board 331 and/or the second printed circuit board 332 and the third printed circuit board 333 may be electrically connected through an electrical connection member 334. In another example, the electrical connection member 334 may connect the first printed circuit board 331 and/or the second printed circuit board 332 and the third printed circuit board 333 by crossing the battery 370 disposed in the support member 322. For example, the electrical connection member 334 may include at least one of an FPCB, a coaxial cable, and a board to board (B to B) connector, but is limited thereto.

According to an embodiment, the printed circuit board structure 330 may include an area (hereinafter, referred to as a "flexible area") having the bending or flexible property. In one example, the flexible area may include a base film (or a substrate) and a copper foil layer. For example, the flexible area may be a flexible copper clad layer (FCCL) in which at least one copper clad is laminated on at least a part of at least one region of a top or a bottom of a polyimide film.

According to an embodiment, the first printed circuit board 331 and/or the second printed circuit board 332 of the printed circuit board structure 330 may be electrically connected to a fourth printed circuit board (not shown) disposed away from the printed circuit board structure 330. For example, the fourth printed circuit board (not shown) may be a flexible printed circuit board (or "flexible printed circuit board") type radio frequency cable (FRC). In an embodiment, the fourth printed circuit board may be disposed on at least a part of the support member 322. For example, the fourth printed circuit board may be disposed in one region (e.g., a region of the +x direction of FIG. 4) and/or another region (e.g., a region of the -x direction of FIG. 4) of the support member 322.

According to an embodiment, the shielding structure 350 (or a "shield can") may be formed of a conductive material (e.g., metal), and disposed in at least one region of the printed circuit board structure 330 to electromagnetically shield the plurality of the electronic components disposed on the printed circuit board structure 330. In one example, the shielding structure 350 may be disposed at least in part on the second printed circuit board 332 of the printed circuit board structure 330, and may electromagnetically shield the plurality of the electronic components disposed on the second printed circuit board 332.

According to an embodiment, the rear case 360 may be disposed on the -z direction of the printed circuit board structure 330, to protect the first printed circuit board 331 and/or the second printed circuit board 332 and the plurality of the electronic components disposed on the first printed circuit board 331 and/or the second printed circuit board 332 from an external force applied to the electronic device 300. In an example, the rear case 360 may be formed of a nonconductive material (e.g., plastic), but is not limited thereto. The rear case 360 may be omitted in the electronic device 300 according to another embodiment (not shown).

According to an embodiment, the battery 370 may be disposed inside the electronic device 300, to supply power to at least one component of the electronic device 300. The battery 370 may include, for example, a non-rechargeable primary cell, a rechargeable secondary cell, or a fuel cell. In an example, the battery 370 may be disposed in a battery groove (not shown) formed in at least one region of the support member 322, to supply the power to the components of the electronic device 300. According to an embodiment, the battery 370 may be integrally disposed in the electronic device 300 but is not limited thereto, and the battery 370 may be disposed detachably from the electronic device 300 according to another embodiment.

According to an embodiment, the rear plate 380 may form a rear surface (e.g., the second surface 210B of FIG. 3) of the electronic device 300. The rear plate 380 may protect the internal components of the electronic device 300 from an external impact or inflow of foreign substances.

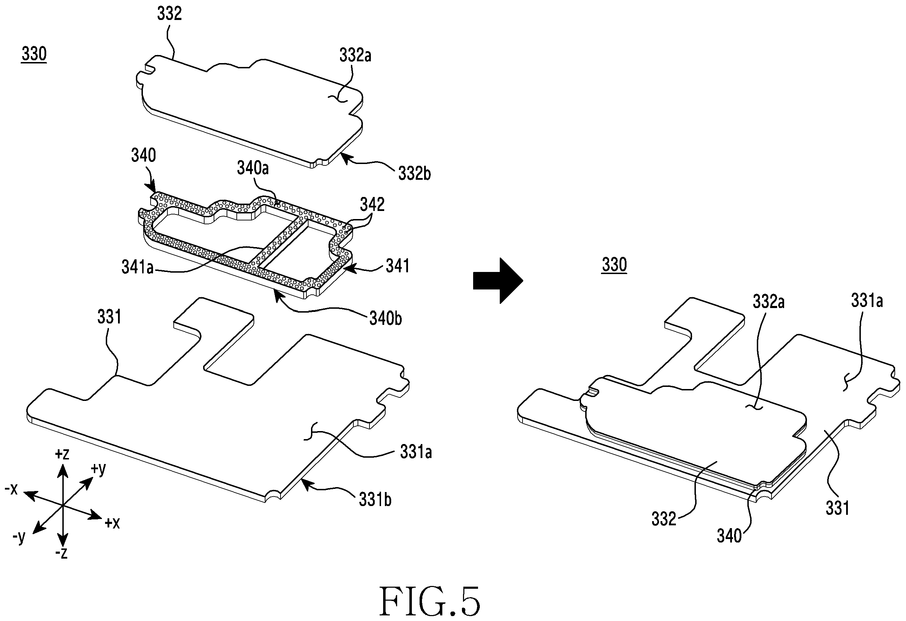

FIG. 5 is an exploded view and an assembled view of a printed circuit board structure according to an embodiment.

FIG. 5 depicts that the first printed circuit board 331, the second printed circuit board 332 and/or the interposer 340 of the printed circuit board structure 330 of FIG. 4 are disassembled and the first printed circuit board 331, the second printed circuit board 332 and/or the interposer 340 are assembled.

Referring to FIG. 5, a printed circuit board structure 330 (e.g., the printed circuit board structure 330 of FIG. 4) according to an embodiment may include a first printed circuit board 331 (e.g., the first printed circuit board 331 of FIG. 4), a second printed circuit board 332 (e.g., the second printed circuit board 332 of FIG. 4) and/or an interposer 340 (e.g., the interposer 340 of FIG. 4).

According to an embodiment, the first printed circuit board 331 may include a first surface 331a facing the +z direction and/or a second surface 331b facing away from the first surface 331a. In one example, at least one electronic component (not shown) may be disposed on at least one of the first surface 331a or the second surface 331b of the first printed circuit board 331. For example, the at least one electronic component may include a processor (e.g., the processor 120 of FIG. 1), a memory (e.g., the memory 130 of FIG. 1), a communication circuit (e.g., the communication module 190 of FIG. 1) or a power management module (e.g., the power management module 188 of FIG. 1) required for operating the electronic device, but is not limited thereto.

According to an embodiment, the second printed circuit board 332 may be disposed away from the first printed circuit board 331. For example, the second printed circuit board 332 may be disposed on the first surface 331a (e.g., the +z direction of FIG. 5) of the first printed circuit board 331. In one example, the second printed circuit board 332 may include a third side 332a facing the +z direction and/or a fourth surface 332b facing away (e.g., the -z direction of FIG. 5) from the third surface 332a, and facing at least one region of the first surface 331a of the first printed circuit board 331. In another example, at least one electronic component (not shown) may be disposed on the third surface 332a and/or the fourth surface 332b of the second printed circuit board 332. The at least one electronic component may include, for example, at least one of a processor, a memory, a communication circuit, and a power management module, but is not limited thereto.

According to an embodiment, the interposer 340 may be interposed between the first printed circuit board 331 and the second printed circuit board 332, to stack the second printed circuit board 332 on the first printed circuit board 331 (e.g., the +z direction of FIG. 5). In one example, a lower surface 340b of the interposer 340 may be disposed on at least one region of the first surface 331a of the first printed circuit board 331, and at least one region of the fourth surface 332b of the second printed circuit board 332 may be disposed on an upper surface 340a of the interposer 340. In another example, the first printed circuit board 331 may be secured to the lower surface 340b of the interposer 340, and the second printed circuit board 332 may be secured to the upper surface 340a of the interposer 340. For example, as at least one region of the first surface 331a of the first printed circuit board 331 is soldered to the lower surface 340b of the interposer 340, the first printed circuit board 331 may be secured to the lower surface 340b of the interposer 340. As another example, as at least one region of the fourth surface 332b of the second printed circuit board 332 is soldered to the upper surface 340a of the interposer 340, the second printed circuit board 332 may be secured to the upper surface 340a of the interposer 340.

According to an embodiment, the interposer 340 may include an insulation layer 341 and/or at least one conductive via 342. In one example, the insulation layer 341 may include at least one side wall, and may be disposed to surround a space between the first printed circuit board 331 and the second printed circuit board 332. For example, the insulation layer 341 may be formed in a band shape making a closed-curve formed along at least one edge of the first printed circuit board 331 or the second printed circuit board 332, when viewed from above (e.g., the +z direction in FIG. 5). However, the shape of the insulation layer 341 is not limited to the above-described embodiment. According to another embodiment, the insulation layer 341 may include a partition 341a interconnecting one point and another point of at least one side wall, and supporting the first printed circuit board 331 and/or the second printed circuit board 332.

In another example, some of the at least one electronic component disposed on the first printed circuit board 331 and/or the second printed circuit board 332 may be disposed to be surrounded by the above-described insulation layer 341.

In one example, the at least one conductive via 342 may be formed of a conductive material, and may be disposed by passing through at least one region of the insulation layer 341. In another example, the at least one conductive via 342 may electrically connect the first printed circuit board 331 disposed at a lower end of the interposer 340 (e.g., the -z direction of FIG. 5) and the second printed circuit board 332 disposed at an upper end of the interposer 340 (e.g., the +z direction of FIG. 5). For example, at least one electronic component disposed on the first surface 331a and/or the second surface 331b of the first printed circuit board 331 may be electrically connected with at least one electronic component disposed on the third surface 332a and/or the fourth surface 332b of the second printed circuit board 332 through the at least one conductive via 342.

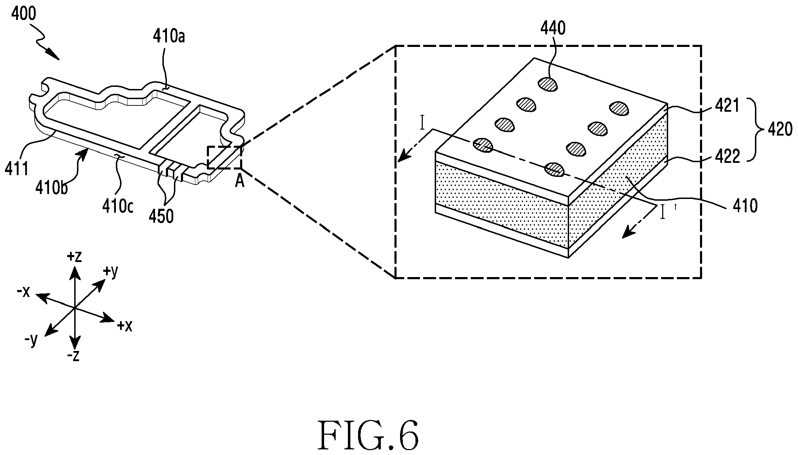

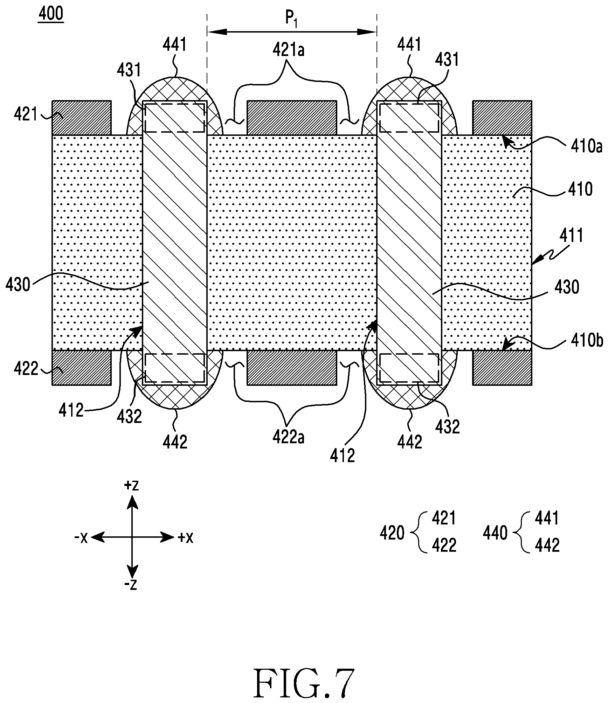

FIG. 6 is an enlarged view of an interposer structure and a region A of the interposer structure according to an embodiment, and FIG. 7 is a cross-sectional view of the interposer structure of FIG. 6 taken along an I-I' direction. An interposer structure 400 shown in FIG. 6 may be one structure of the interposer 340 disposed between the first printed circuit board 331 and the printed circuit board 332 of FIG. 5.

Referring to FIG. 6 and FIG. 7, the interposer structure 400 (or "printed circuit board structure") according to an embodiment may include an insulation layer 410 (e.g., the insulation layer 341 of FIG. 5), at least one solder resist layer (or "solder resist") 420, at least one conductive via 430 (e.g., the at least one conductive via 342 of FIG. 5) and/or a presolder 440.

According to an embodiment, the insulation layer 410 may be formed of a material having a nonconductive material, and may be formed in a closed-curve shape. For example, the insulation layer 410 may be formed in a band shape making a closed curve, when viewed from above (e.g., the +z direction of FIG. 6).

In an embodiment, the insulation layer 410 may include at least one side wall 411 forming a closed curve and having a designated thickness and/or at least one through hole 412 (or "via hole") penetrating at least one region of the insulation layer 410. In one example, the at least one side wall 411 may form at least one side surface of the insulation layer 410. In another example, the at least one through hole 412 may be formed in at least one region of an inner region of the insulation layer 410 spaced apart from the side surface of the insulation layer 410. For example, the at least one through hole 412 may be formed by penetrating from one surface facing the +z direction of the insulation layer 410 to the surface facing the -z direction of the insulation layer 410, but is limited thereto.

According to an embodiment, the at least one solder resist layer 420 may be disposed on at least one region of a top surface 410a and/or a bottom surface 410b of the insulation layer 410. For example, the at least one solder resist layer 420 may prevent lead from joining to one region of the insulation layer 410 on which the at least one solder resist layer 420 is disposed in soldering (or "soldering") an electronic component (e.g., the first printed circuit board 331, the second printed circuit board 332 of FIG. 5) on and/or below the interposer structure 400.

According to an embodiment, the at least one solder resist layer 420 may include a first solder resist layer 421 and/or a second solder resist layer 422. In one example, the first solder resist layer 421 may be disposed on at least one region of the top surface 410a of the insulation layer 410, to prevent lead from joining to the top surface 410a of the insulation layer 410. In another example, the second solder resist layer 422 may be disposed on at least one region of the bottom surface 410b of the insulation layer 410, to prevent lead from joining to the bottom surface 410b of the insulation layer 410.

In one example, the first solder resist layer 421 may include at least one first opening 421a formed at a position corresponding to the at least one through hole 412 of the insulation layer 410. For example, when viewed from above the interposer structure 400 (e.g., the +z direction of FIG. 7), at least one region of the at least one first opening 421a may be disposed to overlap the at least one through hole 412. As another example, the at least one first opening 421a may be formed in a greater area than the at least one through hole 412, and an outer circumferential surface of the at least one first opening 421a may surround an outer circumferential surface of the at least one through hole 412. The shape of the at least one first opening 421a is not limited to the above-described embodiment, and the at least one first opening 421a may be formed in an area smaller than the at least one through hole 412, or may be formed in substantially the same area according to another embodiment (not shown).

In one example, the second solder resist layer 422 may include at least one second opening 422a formed at a position corresponding to the at least one through hole 412 of the insulation layer 410. For example, when viewed from below the interposer structure 400 (e.g., the -z direction of FIG. 7), at least one region of the at least one second opening 422a may be disposed to overlap the at least one through hole 412. As another example, the at least one second opening 422a may be formed in a greater area than the at least one through hole 412, and an outer circumferential surface of the at least one second opening 422a may surround the outer circumferential surface of the at least one through hole 412. The shape of the at least one second opening 422a is not limited to the above-described embodiment, and the at least one second opening 422a may be formed in a smaller area than the at least one through hole 412, or may be formed in substantially the same area according to another embodiment (not shown).

As another example, the at least one second opening 422a may be formed at a position corresponding to the at least one first opening 421a of the first solder resist layer 421. In one example, some region of the insulation layer 410 and/or some region of the at least one conductive via 430 may be exposed to the outside of the interposer structure 400 through the at least one first opening 421a formed in the first solder resist layer 421 and/or the at least one second opening 422a formed in the second solder resist layer 422.

According to an embodiment, the at least one conductive via 430 may be positioned inside the at least one through hole 412 of the insulation layer 410. The at least one conductive via 430 may be formed of a conductive material (e.g., metal), to electrically connect electronic components disposed in the interposer structure 400. For example, the at least one conductive via 430 may electrically connect an electronic component (e.g., the first printed circuit board 331 of FIG. 5) disposed on the interposer structure 400 and an electronic component (e.g., the second printed circuit board 332 of FIG. 5) disposed below the interposer structure 400. As another example, the at least one conductive via 430 may include a conductive via having a cylindrical shape (or a "hole shape"), but is not limited thereto.

In one example, the at least one conductive via 430 may include a first protruding portion 431 protruding from the top surface 410a of the insulation layer 410 in a direction (e.g., the +z direction of FIG. 7) in which the at least one first opening 421a of the first solder resist layer 421 is formed and/or a second protruding portion 432 protruding from the bottom surface 410b of the insulation layer 410 in a direction (e.g., the -z direction of FIG. 7) in which the at least one second opening 422a of the second solder resist layer 422 is formed. For example, the first protruding portion 431 of the at least one conductive via 430 may protrude from the top surface 410a of the insulation layer 410 to one surface toward the +z direction of the first solder resist layer 421. As another example, the second protruding portion 432 of the at least one conductive via 430 may protrude from the bottom surface 410b of the insulation layer 410 to one surface toward the -z direction of the second solder resist layer 422.

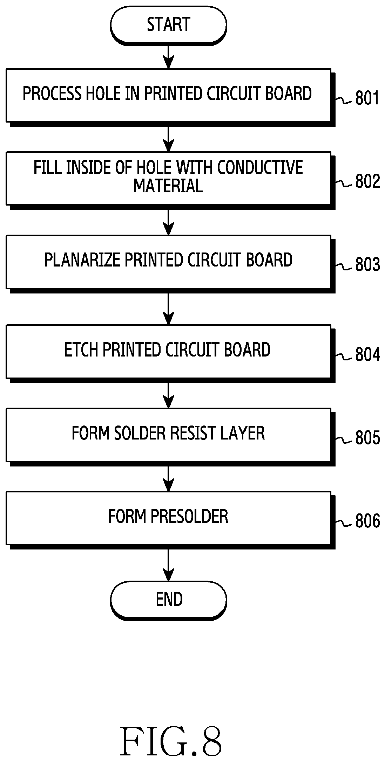

According to an embodiment, the presolder 440 may be disposed on an upper region (e.g., a region of the +z direction of FIG. 7. FIG. 8) and/or a lower region (e.g., a region of the -z direction of FIG. 7. FIG. 8) of the interposer structure 400, to secure the electronic component disposed on and/or below the interposer structure 400 to the interposer structure 400.

In an embodiment, the presolder 440 may include a first presolder 441 and/or a second presolder 442. In one example, the first presolder 441 may be disposed on the first protruding portion 431 of the at least one conductive via 430 exposed to the outside of the interposer structure 400 through the at least one first opening 421a of the first solder resist layer 421. For example, the first presolder 441 may be seated at one end (e.g., one end of the +z direction of FIG. 7) of the first protruding portion 431, and disposed to surround some region of the top surface 410a of the insulation layer 410 and/or some region of the first protruding portion 431. In another example, the second presolder 442 may be disposed on the second protruding portion 432 of the at least one conductive via 430 exposed to the outside of the interposer structure 400 through the at least one second opening 422a of the second solder resist layer 422. For example, the second presolder 442 may be seated at one end (e.g., one end of the -z direction of FIG. 7) of the second protruding portion 432, and disposed to surround some region of the bottom surface 410b of the insulation layer 410 and/or some region of the second protruding portion 432.

According to an embodiment, the interposer structure 400 may secure the electronic components to the top and/or the bottom the interposer structure 400 through the first presolder 441 and/or the second presolder 442. For example, the interposer structure 400 may solder the second printed circuit board (e.g., the second printed circuit board 332 of FIG. 5) onto (e.g., the +z direction of FIG. 7) of the interposer 400 by applying heat to the first presolder 441. As another example, the interposer structure 400 may solder the first printed circuit board (e.g., the first printed circuit board 331 of FIG. 5) below (e.g., the -z direction of FIG. 7) of the interposer 400 by applying heat to the second presolder 442.

According to an embodiment, the interposer structure 400 may form a space for receiving the presolder 440, without forming a land through the at least one conductive via 430 including the first protruding portion 431 and/or the second protruding portion 432 protruding upward and/or downward based on the insulation layer 410. In one example, as the interposer structure 400 is formed in the landless structure not including the land, a pitch P₁ between the conductive vias 430 may not be spaced over a designated pitch to secure the space for the land. For example, the above-described interposer structure 400 having the landless structure may form a shorter pitch between the conductive vias 430 than the interposer structure including the land. According to an embodiment, by forming the smaller pitch P₁ between the conductive vias 430, the interposer structure 400 may densely arrange or mount electronic components on the plurality of the printed circuit boards (e.g., the first printed circuit board 331, the second printed circuit board 332 of FIG. 5) disposed on and/or below the interposer structure 400.

According to an embodiment, the interposer structure 400 may further include a side plating portion 450. In one example, the side plating portion 450 may be positioned in at least one region of the side surface 410c of the insulation layer 410, to electromagnetically shield the interposer structure 400. In the present disclosure, the side surface 410c of the insulation layer 410 may indicate a surface positioned between the top surface 410a and the bottom surface 410b of the insulation layer 410, and surrounding the space between the top surface 410a and the bottom surface 410b. For example, the side plating portion 450 may shield noise generated inside the interposer structure 400 (e.g., noise generated from the electronic components) leaking to the outside of the interposer structure 400, or shield noise introduced from the outside of the structure 400.

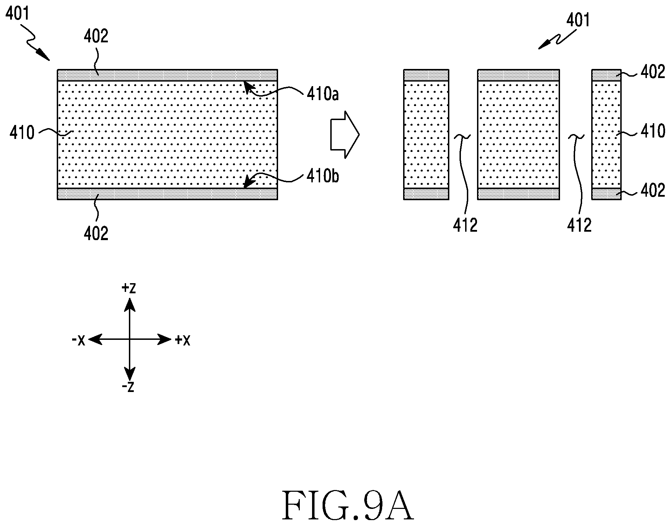

Hereinafter, a manufacturing process of the interposer structure 400 according to an embodiment shall be described, with reference to FIG. 8 and FIG. 9A through FIG. 9E.

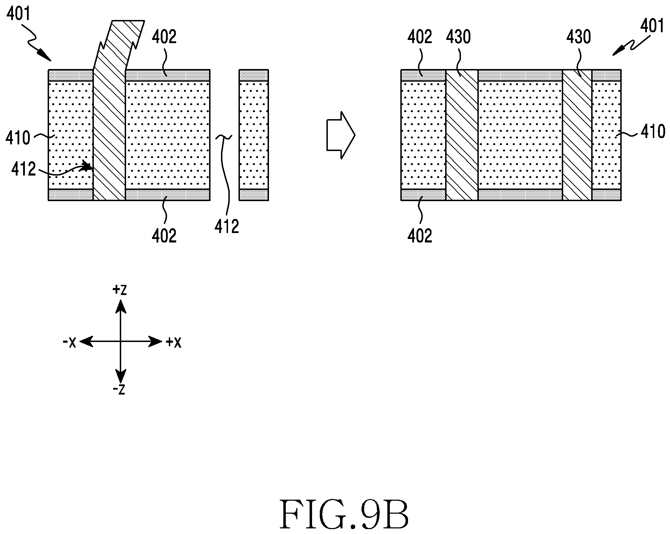

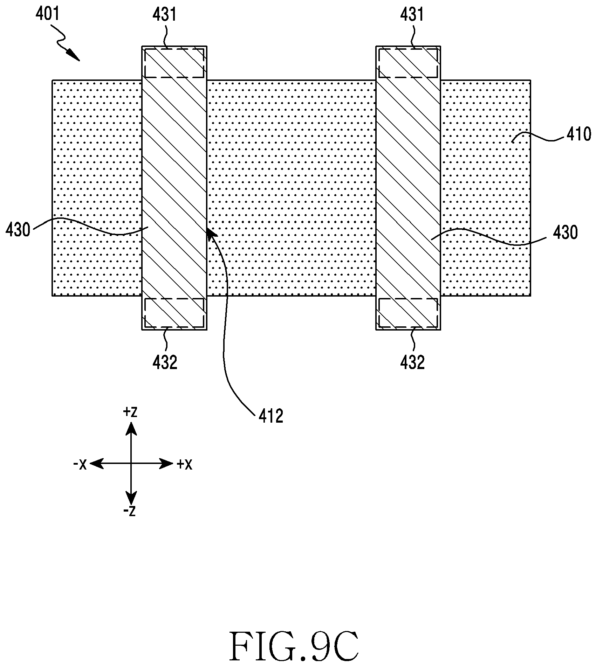

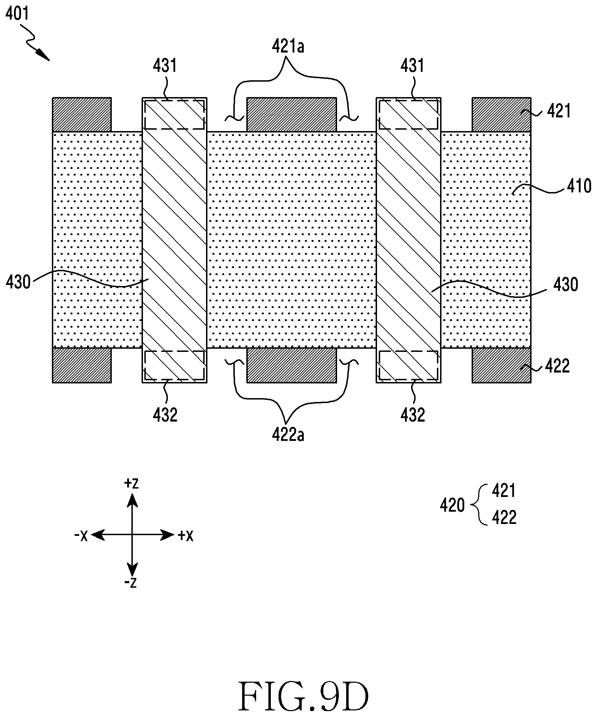

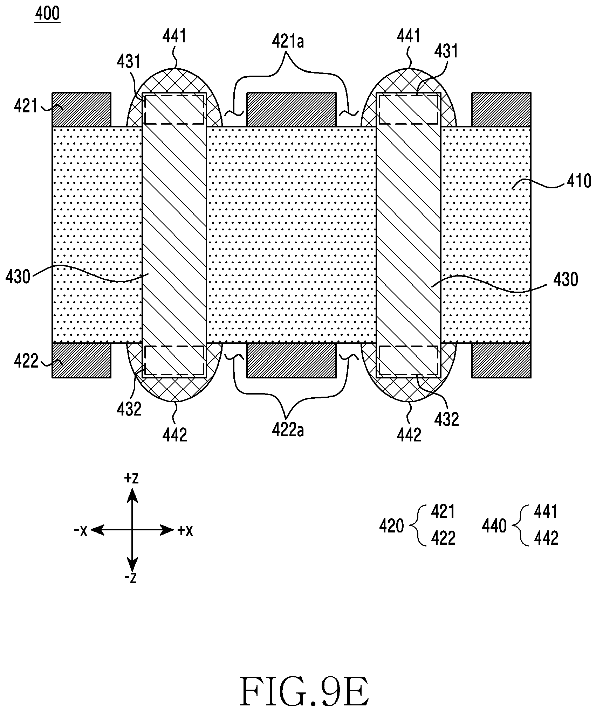

FIG. 8 is a flowchart illustrating manufacturing operations of an interposer structure according to an embodiment, FIG. 9A is a diagram for explaining an operation of forming at least one through hole in a printed circuit board, according to an embodiment, FIG. 9B is a diagram for explaining an operation of filling an inside of the at least one through hole with a conductive material, and planarizing the printed circuit board, according to an embodiment, FIG. 9C is a diagram for explaining an operation of etching the printed circuit board, according to an embodiment, FIG. 9D is a diagram for explaining an operation of forming a solder resist layer onto and/or below the printed circuit board, according to an embodiment, and FIG. 9E is a diagram for explaining an operation of forming a presolder, according to an embodiment.

FIG. 9A through FIG. 9E show the manufacturing operations of some region (e.g., the region A of FIG. 6) of the interposer structure (or "printed circuit board structure"), and other region of the interposer structure may be manufactured through the same operations. Hereinafter, the manufacturing operations of the interposer structure of FIG. 8 shall be described with reference to the configurations of FIG. 9A through FIG. 9E.

Referring to FIG. 8 and FIG. 9A, the manufacturing operations of the interposer structure according to an embodiment, may form at least one through hole 412 (or "via hole") (e.g., the at least one through hole 412 of FIG. 7) which penetrates at least one region of a printed circuit board 401, by processing the printed circuit board 401 in operation 801. For example, the printed circuit board 401 may include an insulation layer 410 (e.g., the insulation layer 410 of FIG. 7) and/or a copper foil 402 (or "copper clad") disposed on a top surface 410a (e.g., the top surface 410a of FIG. 7) and a bottom surface 410b (e.g., the bottom surface 410b of FIG. 7) of the insulation layer 410, and the at least one through hole 412 may pass through at least one region of the insulation layer 410 and the copper foil 402. According to an embodiment, the at least one through hole 412 may be formed by drilling at least one region of the printed circuit board 401. However, the drilling process is merely an example of the processing for forming the at least one through hole 412, and the at least one through hole 412 may be formed through laser processing or punching processing, according to another embodiment.

Referring to FIG. 8 and FIG. 9B, the interposer structure manufacturing operations according to an embodiment may fill an inside of the at least one through hole 412 formed in the printed circuit board 401 with a conductive material (or "conductive material") in operation 802. In one example, operation 802 may fill the inside of the at least one through hole 412 with the conductive material through a hole plugging printing technique, but filling the inside of the at least one through hole 412 with the conductive material is not limited to the above-described embodiment. In another example, the conductive material filling inside the at least one through hole 412 may be other material than the copper. The conductive material may include, for example, at least one of silver paste, aluminum, silver-aluminum, carbon paste or carbon nanotube (CNT) paste, but is not limited thereto.

In operation 803, the interposer structure manufacturing operations according to an embodiment may planarize (or "polish") the top surface and/or the bottom surface of the printed circuit board 401. For example, a region protruding toward and/or downward the printed circuit board 401 may be formed in filling the inside of the at least one through hole 412 with the conductive material in operation 802. The interposer structure manufacturing operations according to an embodiment, may form at least one conductive via 430 (e.g., the conductive vias 430 of FIG. 7), by planarizing the region protruding toward and/or downward the printed circuit board 401 in operation 803. In an example, operation 803 may planarize the top surface and/or the bottom surface of the printed circuit board 401 through brushing or buffing. In another example, operation 803 may planarize the top surface and/or the bottom surface of the printed circuit board 401 through polishing process. For example, the polishing may include at least one of mechanical polishing or chemical mechanical polishing (CMP).

Referring to FIG. 8 and FIG. 9C, the interposer structure manufacturing operations according to an embodiment may remove the copper foil 402 disposed on the upper surface and the lower surface of the insulation layer 410, by etching the top surface and/or the bottom surface of the printed circuit board 401 in operation 804. In one example, since the at least one conductive via 430 is formed of other material than copper, the at least one conductive via 430 may not be removed in the process of etching the top surface and/or bottom surface of the printed circuit board 401. In another example, as the copper foil 402 disposed on the top surface 410a and the bottom surface 410b of the insulation layer 410 is removed, some region of the at least one conductive via 430 protruding from the top surface 410a and/or the bottom surface of the insulation layer 410 may be formed. For example, operation 804 may form a first protruding portion 431 (e.g., the first protruding portion 431 of FIG. 7) of the at least one conductive via 430 protruding from the top surface 410a of the insulation layer 410 in the +z direction and/or a second protruding portion 432 (e.g., the second protruding portion 432 of FIG. 7) of the at least one conductive via 430 protruding from the bottom surface 410b of the insulation layer 410 in the -z direction.

Referring to FIG. 8 and FIG. 9D, the interposer structure manufacturing operations according to an embodiment may form a solder resist layer 420 (e.g., the solder resist layer 420 of FIG. 7) in at least one region of the top surface 410a and/or the bottom surface 410b of the insulation layer 410 in operation 805. In one example, operation 805 may form the solder resist layer 420 through a process of spreading solder resist ink to other region than the region in which the at least one conductive via 430 is disposed in the top surface 410a and/or the bottom surface 410b of the insulation layer 410, and then curing the spread ink by applying ultraviolet (UV) ray to the spread ink, but is not limited thereto. For example, a first solder resist layer 421 (e.g., the first solder resist layer 421 of FIG. 7) may be formed on the top surface 410a of the insulation layer 410, and a second solder resist layer 422 (e.g., the second solder resist layer 422 of FIG. 7) may be formed on the bottom surface 410b of the layer 410 in operation 805. As another example, as the solder resist ink is applied to the other region than the region in which the conductive vias 430 are disposed, at least one opening 421a (e.g., the at least one first opening 421a of FIG. 7) may be formed in the region corresponding to the at least one conductive via 430 of the first solder resist layer 421. Similarly, at least one second opening 422a (e.g., the at least one second opening 422a of FIG. 7) may be formed in the region corresponding to the at least one conductive via 430 of the second solder resist layer 422.

Referring to FIG. 8 and FIG. 9E, the interposer structure manufacturing operations according to an embodiment may form a presolder 440 (e.g., the presolder 440 of FIG. 7) in the first protruding portion 431 and/or the second protruding portion 432 of the at least one conductive via 430 in operation 806. In one example, a first presolder 441 may be formed in at least one region of the first protruding portion 431 of the at least one conductive via 430, and a second presolder 442 may be formed in at least one region of the second protruding portion 432 of the at least one conductive via 430 in operation 806. The first presolder 441 and/or the second presolder 442 may be formed through a process (or "reflow process") of applying or squeezing solder cream (or "solder paste") to the first protruding portion 431 and/or the second protruding portion 432 using, for example, a metal mask, and then melting the applied solder cream, but it is not limited thereto.

The manufacturing operations of the interposer structure according to an embodiment may manufacture the interposer structure 400 not including a land for receiving the presolder 440 in operation 801 through FIG. 806 described above. Although not depicted in the drawings, the manufacturing operations of the interposer structure according to an embodiment, may further include forming a side plating portion (e.g., the side plating portion 450 of FIG. 6) for electromagnetically shielding the interposer structure 400 in at least one region of the side surface (e.g., the side surface 410c of FIG. 6) of the insulation layer 410. In one example, forming the side plating portion may include plating the side surface of the insulation layer 410, and then attaching a dry film to at least one region of the side surface of the insulation layer 410 where the side plating portion is to be formed. In another example, by exposing, developing, and etching at least one region of the side surface of the insulation layer 410 to which the dry film is attached, and then peeling the dry film attached to the insulation layer 410, the side plating portion may be formed in at least one region of the side surface of the insulation layer 410.

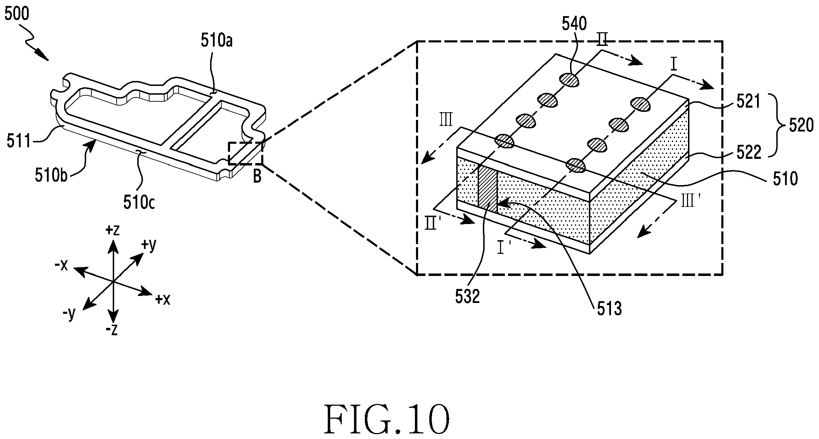

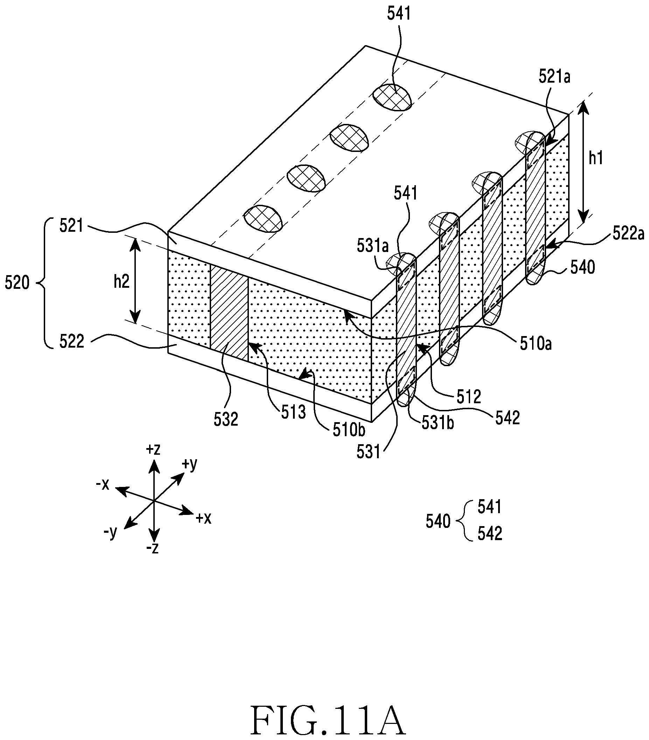

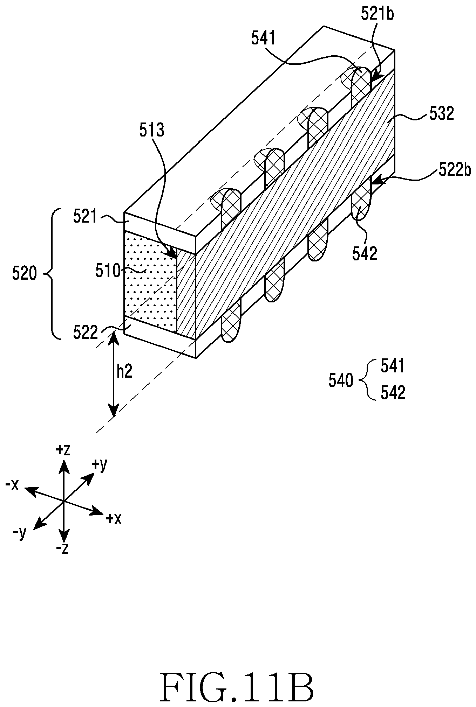

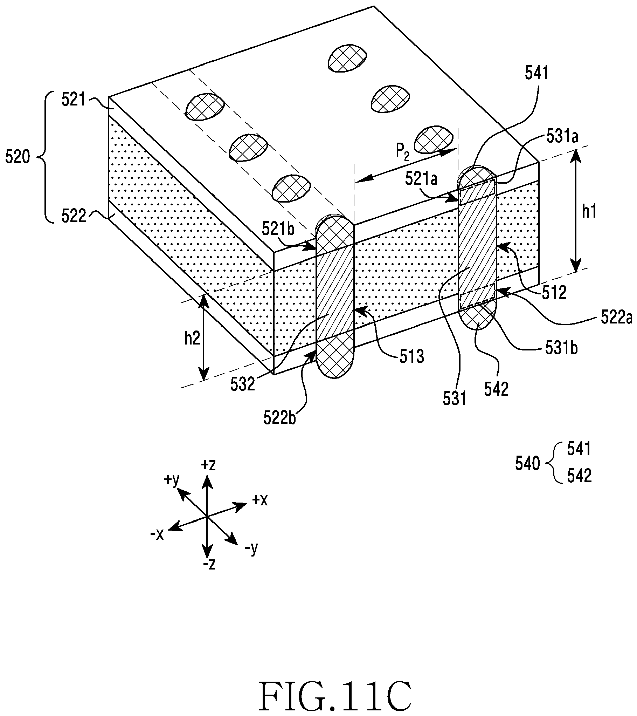

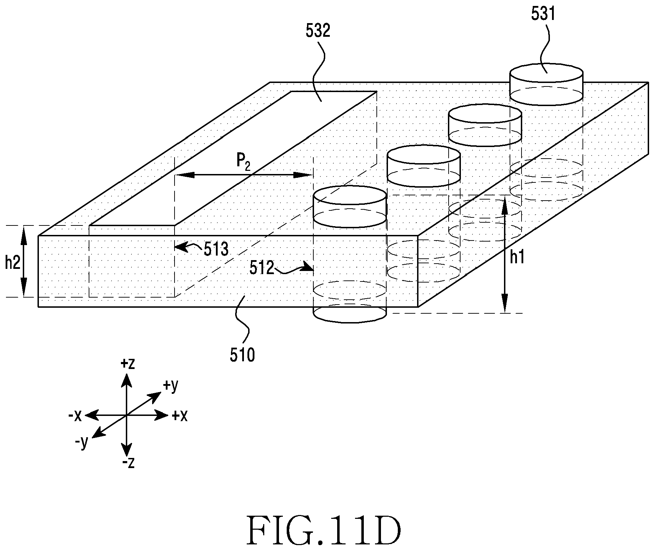

FIG. 10 is an enlarged view of an interposer structure and a region B of the interposer structure according to another embodiment, FIG. 11A is a cross-sectional view of the interposer structure of FIG. 10 taken along a I-I' direction, FIG. 11B is a cross-sectional view of the interposer structure of FIG. 10 taken along a II-II' direction, FIG. 11C is a cross-sectional view of the interposer structure of FIG. 10 taken along a III-III' direction, and FIG. 11D is a diagram illustrating that a solder resist layer and/or a presolder are removed from the interposer structure of FIG. 10.

An interposer structure 500 shown in FIG. 10 may be one structure of the interposer 340 disposed between the first printed circuit board 331 and the second printed circuit board 332 of FIG. 5.

Referring to FIG. 10, FIG. 11A, FIG. 11B, FIG. 11C, and FIG. 11D, the interposer structure 500 (or "printed circuit board structure") according to an embodiment may include an insulation layer 510 (e.g., the insulation layer 341 of FIG. 5), at least one solder resist layer (or "solder resist") 520, at least one first conductive via 531, at least one second conductive via 532 and/or a presolder 540.

According to an embodiment, the insulation layer 510 may be formed of a material having a nonconductive material, and may be formed in a closed-curve shape. For example, the insulation layer 510 may be formed in a band shape making a closed curve, when viewed from above (e.g., the +z direction of FIG. 10).

In an embodiment, the insulation layer 510 may include at least one side wall 511 forming a closed curve and having a designated thickness, at least one through hole 512 (or "via hole") penetrating at least one region of the insulation layer 510 and/or a slot 513 penetrating at least one region of the insulation layer 510. In one example, the at least one side wall 511 may form at least one side surface of the insulation layer 510. In another example, the at least one through hole 512 may be formed in at least one region of an inner region of the insulation layer 510 spaced apart from the side surface of the insulation layer 510. For example, the at least one through hole 512 may be formed by penetrating from one surface facing the +z direction of the insulation layer 510 to one surface facing the -z direction of the insulation layer 510, but is limited thereto. In another example, the slot 513 may be formed in at least one region of the inner region of the insulation layer 510 spaced apart from the side surface of the insulation layer 510. For example, the slot 513 may be formed by penetrating from one surface facing the +z direction of the insulation layer 510 to one side facing the -z direction of the insulation layer 510, in a substantially identical or similar manner to the at least one through hole 512, but is not limited thereto. In one example, the slot 513 may be disposed apart from the at least one through hole 512. In another example, the slot 513 may be formed in a rectangular bar shape, when viewed from above the insulation layer 510 (e.g., the +z direction of FIG. 11D). For example, the slot 513 may be formed in a rectangular shape, when viewed from above the insulation layer 510. As another example, the slot 513 may be formed to have a greater area than the at least one through hole 512, but is not limited thereto.

According to an embodiment, the at least one solder resist layer 520 may be disposed on at least one region of a top surface 510a and/or a bottom surface 510b of the insulation layer 510. For example, the at least one solder resist layer 520 may prevent lead from joining to one region of the insulation layer 510 on which the at least one solder resist layer 520 is disposed while soldering (or "soldering") an electronic component (e.g., the first printed circuit board 331, the second printed circuit board 332 of FIG. 5) onto the top and/or the bottom of the interposer structure 500.

According to an embodiment, the at least one solder resist layer 520 may include a first solder resist layer 521 and/or a second solder resist layer 522. In one example, the first solder resist layer 521 may be disposed on at least one region of the top surface 510a of the insulation layer 510, to prevent lead from joining to the top surface 510a of the insulation layer 510. In another example, the second solder resist layer 522 may be disposed on at least one region of the bottom surface 510b of the insulation layer 510, to prevent lead from joining to the bottom surface 510b of the insulation layer 510.

In one example, the first solder resist layer 521 may include at least one first opening 521a formed at a position corresponding to the at least one through hole 512 of the insulation layer 510 and/or at least one second opening 521b formed at a position corresponding to at least one region of the slot. For example, when viewed from above the interposer structure 500 (e.g., the +z direction of FIG. 11A), at least one region of the at least one first opening 521a may be disposed to overlap the at least one through hole 512. As another example, when viewed from above the interposer structure 500, at least one region of the at least one second opening 521b may be disposed to overlap one region of the slot 513.

In one example, the second solder resist layer 522 may include at least one third opening 522a formed at a position corresponding to the at least one through hole 512 of the insulation layer 510 and/or at least one fourth opening 522b formed at a position corresponding to one region of the slot 513 of the insulation layer 510. For example, when viewed from below the interposer structure 500 (e.g., the -z direction of FIG. 11A), at least one region of the at least one third opening 522a may be disposed to overlap the at least one through hole 512. As another example, when viewed from below the interposer structure 500, at least one region of the at least one fourth opening 522b may be disposed to overlap one region of the slot 513. In another example, the at least one third opening 522a may be formed at a position corresponding to the at least one first opening 521a of the first solder resist layer 521, and the at least one fourth opening 522b may be formed at a position corresponding to the at least one second opening 522b of the first solder resist layer 521.

According to an embodiment, the at least one first conductive via 531 may be positioned inside the at least one through hole 512 of the insulation layer 510. For example, the at least one first conductive via 531 may be formed in a cylindrical shape (or "hole shape"), but the shape of the at least one first conductive via 531 is limited to the above-described embodiment. In one example, the at least one first conductive via 531 may be formed of a conductive material (e.g., metal), to electrically interconnect electronic components disposed on the top (e.g., the +z direction of FIG. 10) and/or the bottom (e.g., the -z direction of FIG. 10) of the interposer structure 500. For example, the at least one first conductive via 531 may electrically interconnect an electronic component (e.g., the first printed circuit board 331 of FIG. 5) disposed below (e.g., the -z direction of FIG. 10) of the interposer structure 500 and an electronic component (e.g., the second printed circuit board 332 of FIG. 5) disposed on (e.g., the +z direction of FIG. 10) of the interposer structure 500.

According to an embodiment, the at least one second conductive via 532 may be positioned inside the slot 513 of the insulation layer 510. For example, the at least one second conductive via 532 may be formed in a rectangular bar shape having designated length and/or thickness, but the shape of the at least one second conductive via 532 is not limited to the embodiment described above. In one example, the at least one second conductive via 532 may be formed of a conductive material, to electrically connect electronic components disposed on the top and/or the bottom of the interposer structure 500 in a substantially identical or similar manner to the at least one first conductive via 531.

In another example, the at least one second conductive via 532 may not only electrically connect the electronic components, but also serve as a ground for electromagnetically shielding the interposer structure 500. For example, the at least one second conductive via 532 may be formed in a relatively greater area than the at least one first conductive via 531 to serve as the ground, and may shield noise introduced to the interposer structure 500, or leaking from the interposer structure 500. In another example, the at least one second conductive via 532 may be disposed in a region adjacent to the side surface 510c of the insulation layer 510, thus shielding noise introduced from the side surface of the interposer structure 500, or shielding noise laterally leaking out of the interposer structure 500.

The interposer structure 500 according to an embodiment may electromagnetically shield noise introduced into the interposer structure 500 from the outside, or leaking out of the interposer structure 500 without forming a separate plating portion (e.g., the side plating portion 450 of FIG. 6) on the side surface of the insulation layer 510, by means of the at least one second conductive via 532. That is, the interposer structure 500 according to an embodiment, which may electrically connect the electronic components and omit the plating portion manufacturing through the at least one second conductive via 532, may simplify the manufacturing, and reduce the manufacturing cost.

Referring to FIG. 11A, FIG. 11B, FIG. 11C and/or FIG. 11D, according to an embodiment, the at least one first conductive via 531 and the at least one second conductive via 532 may be formed to have different heights. In an embodiment, the at least one first conductive via 531 may be formed to have a first height hi, and the at least one second conductive via 532 may be formed to have a second height h₂ which is lower than the first height hi. For example, since the at least one second conductive via 532 is formed inside the slot 513 having the greater area than the at least one through hole 512, it may be formed to have the lower height than the at least one first conductive via 531, and descriptions thereof shall be provided later.

In one example, the at least one first conductive via 531 may include a first protruding portion 531a protruding from the top surface 510a of the insulation layer 510 in a direction (e.g., the +z direction of FIG. 11C) in which the at least one first opening 521a of the first solder resist layer 521 is formed and/or a second protruding portion 531b protruding from the bottom surface 510b of the insulation layer 510 in a direction (e.g., the -z direction of FIG. 11C) in which the at least one third opening 522a of the second solder resist layer 522 is formed. For example, the first protruding portion 531a may protrude from the top surface 510a of the insulation layer 510 to one surface facing the +z direction of the first solder resist layer 521. As another example, the second protruding portion 531b may protrude from the bottom surface 510b of the insulation layer 510 to one surface facing the -z direction of the second solder resist layer 522.

In another example, the at least one second conductive via 532 may be formed at substantially the same height as the insulation layer 510. For example, when the insulation layer 510 is viewed from the side surface (e.g., the -y direction of FIG. 11C), one end of the at least one second conductive via 532 (e.g., one end of the +z direction of FIG. 10) may be positioned on the same line as the top surface 510a of the insulation layer 510, and the other end (e.g., one end of the -z direction of FIG. 10) may be positioned on the same line as the bottom surface 510b of the insulation layer 510. As another example, some region of the at least one second conductive via 532 may be exposed to the outside of the interposer structure 500 through the second opening 521b of the first solder resist layer 521 and/or the fourth opening 522b of the second solder resist layer 522.

According to an embodiment, the presolder 540 may be disposed in a top region (e.g., a region of the +z direction of FIG. 10) and/or a bottom region (e.g., a region of the -z direction of FIG. 10) of the interposer structure 500, to secure the electronic component disposed at the top and/or the bottom of the interposer structure 500 to the interposer structure 500.

In an embodiment, the presolder 540 may include a first presolder 541 and/or a second presolder 542. In one example, the first presolder 541 may be disposed in the first protruding portion 531a of the at least one first conductive via 531 exposed to the outside of the interposer structure 500 through the at least one first opening 521a and/or one region of the at least one second conductive via 532 exposed to the outside of the interposer structure 500 through the at least one second opening 521b. For example, the first presolder 541 may be received in one end of the first protruding portion 531a (e.g., one end of the +z direction of FIG. 11C) and/or one end of the at least one second conductive via 532 (e.g., one end facing the +z direction of FIG. 11C).

In another example, the second presolder 542 may be disposed in the second protruding portion 531b of the at least one first conductive via 531 exposed to the outside of the interposer structure 500 through the at least one third opening 522a and/or one region of the at least one second conductive via 532 exposed to the outside of the interposer structure 500 through the at least one fourth opening 522b. For example, the second presolder 542 may be received in the other end of the second protruding portion 531b (e.g., one end of the -z direction of FIG. 11C) and/or the other end of the at least one second conductive via 532 (e.g., one end of the -z direction of FIG. 11C).

According to an embodiment, the interposer structure 500 may secure electronic components to the top and/or the bottom of the interposer structure 500 through the first presolder 541 and/or the second presolder 542. For example, the interposer structure 500 may solder a second printed circuit board (e.g., the second printed circuit board 332 of FIG. 5) to the top (e.g., the +z direction in FIG. 10, FIG. 11C) of the interposer structure 500 by applying heat to the first presolder 541. As another example, the interposer structure 500 may solder a first printed circuit board (e.g., the first printed circuit board 331 of FIG. 5) to the bottom (e.g., the -z direction of FIG. 10, FIG. 11C) of the interposer structure 500 by applying heat to the second presolder 542.

According to an embodiment, the interposer structure 500 may form a space for receiving the presolder 540, without forming a separate land through the at least one first conductive via 531 including the first protruding portion 531a and/or the second protruding portion 531b and/or the at least one second conductive via 532 of the bar shape. In one example, as the interposer structure 500 is formed as a landless structure not including the land, a pitch P₂ between the at least one first conductive via 531 and at least one second conductive via 532 may not be spaced apart over a designated pitch to secure the space for forming the land. For example, the above-described interposer structure 500 having the landless structure may form the pitch P₂ between the at least one first conductive via 531 and the at least one second conductive via 532 to be closer than the interposer structure including the land. According to an embodiment, by forming the pitch between the at least one first conductive via 531 and the at least one second conductive via 532 to be close, the interposer structure 500 may densely arrange or mount the electronic components on a plurality of printed circuit boards (e.g., the first printed circuit board 331, the second printed circuit board 332 of FIG. 5) disposed at the top and/or the bottom of the interposer structure 500.

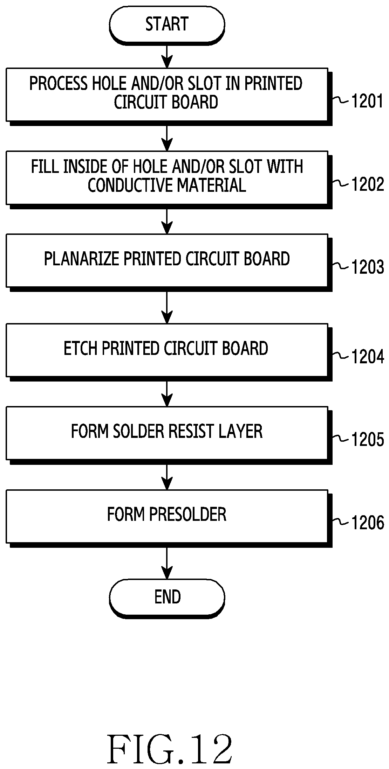

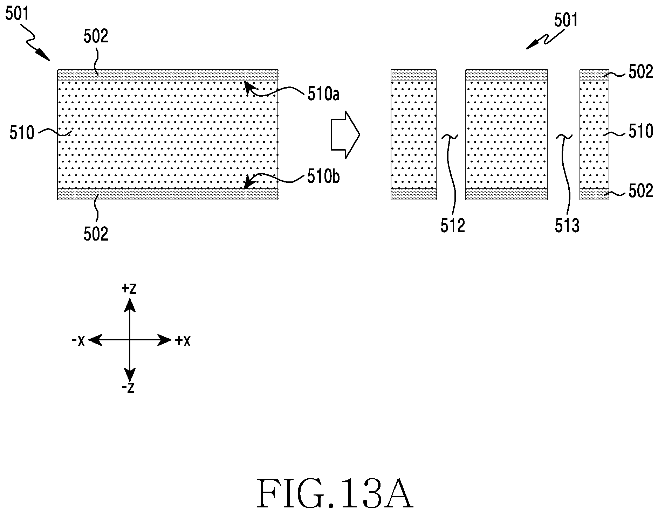

Hereafter, manufacturing of an interposer structure 500 according to an embodiment shall be described, with reference to FIG. 12 and FIG. 13A through FIG. 13E.

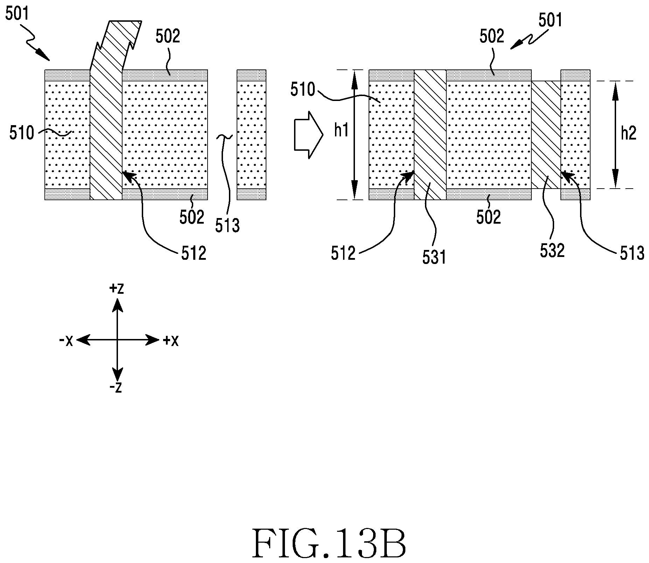

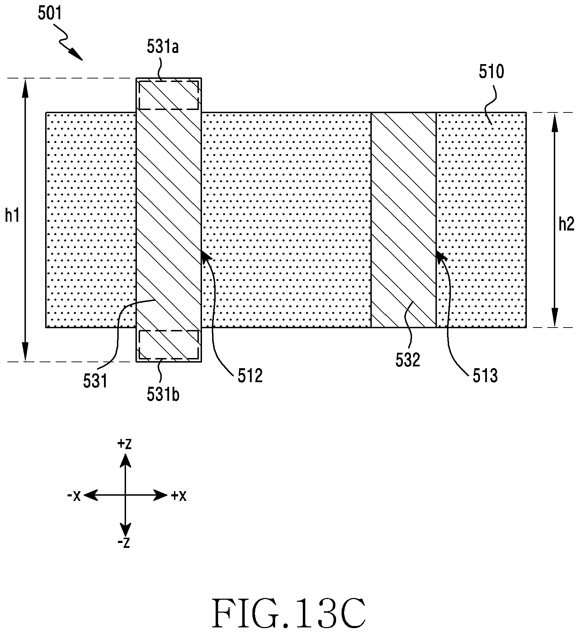

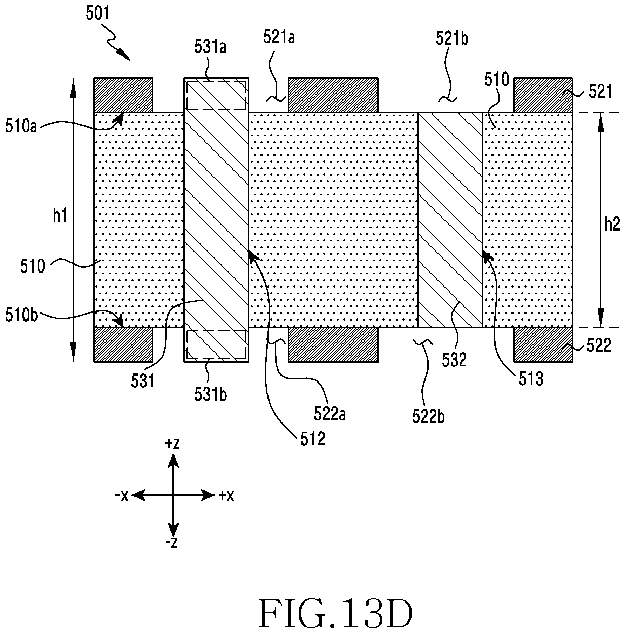

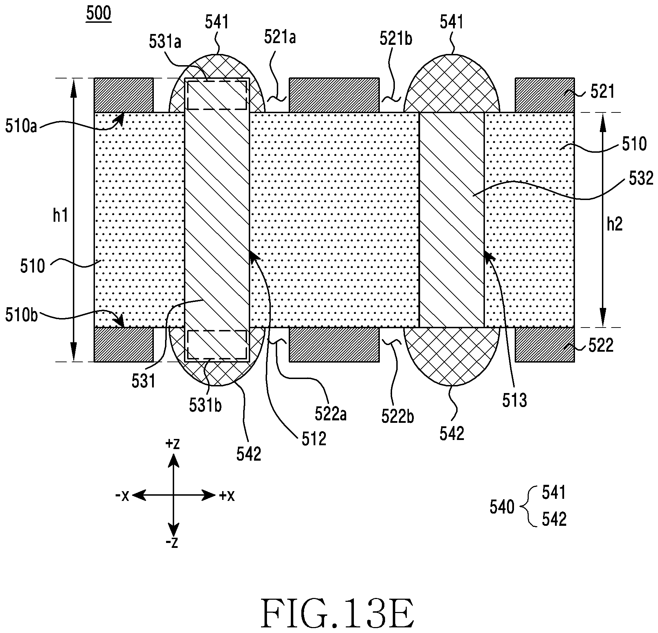

FIG. 12 is a flowchart illustrating manufacturing operations of an interposer structure according to another embodiment, FIG. 13A is a diagram for explaining an operation of forming at least one through hole and/or a slot in a printed circuit board, according to an embodiment, FIG. 13B is a diagram for explaining an operation of filling an inside of the at least one through hole and/or the slot with a conductive material, and planarizing the printed circuit board, according to an embodiment, FIG. 13C is a diagram for explaining an operation of etching the printed circuit board, according to an embodiment, FIG. 13D is a diagram for explaining an operation of forming a solder resist layer on a top surface and/or a bottom surface of the printed circuit board, according to an embodiment, and FIG. 13E is a diagram for explaining an operation of forming a presolder, according to an embodiment.

FIG. 13A through FIG. 13E show the manufacturing operations of some region (e.g., the region B of FIG. 10) of the interposer structure (or "printed circuit board structure"), and other regions of the interposer structure may be manufactured through the same operations. Hereinafter, the manufacturing operations of the interposer structure of FIG. 12 shall be described with reference to the configurations of FIG. 13A through FIG. 13E.

Referring to FIG. 12 and FIG. 13A, the manufacturing operations of the interposer structure according to an embodiment may form at least one through hole 512 (or "via hole") (e.g., the at least one through hole 512 of FIG. 11C) penetrating at least one region of a printed circuit board 501 and/or a slot 513 (e.g., the slot 513 of FIG. 11C), by processing the printed circuit board 501 in operation 1201. For example, the printed circuit board 501 may include an insulation layer 510 (e.g., the insulation layer 510 of FIG. 11A) and/or a copper foil 502 (or "copper clad") disposed on a top surface 510a (e.g., the top surface 510a of FIG. 11A) and a bottom surface 510b (e.g., the bottom surface 510b of FIG. 11A) of the insulation layer 510, and the at least one through hole 512 may pass through at least one region of the insulation layer 510 and the copper foil 502. According to an embodiment, the at least one through hole 512 may be formed by drilling at least one region of the printed circuit board 501. However, the drilling is only an example of processing for forming the at least one through hole 512, and the at least one through hole 512 may be formed through laser processing or punching, according to another embodiment. According to an embodiment, the slot 513 may be formed to have a relatively greater area than the at least one through hole 512, and may be formed in a substantially identical or similar to the processing for forming the at least one through hole 512. For example, the slot 513 may be formed through at least one processing of a plurality of drilling, a plurality of punching, or a plurality of laser processing, but is not limited thereto.

Referring to FIG. 12 and FIG. 13B, the interposer structure manufacturing operations according to an embodiment may fill inside of the at least one through hole 512 and/or the slot 513 formed in the printed circuit board 501 with a conductive material in operation 1202. In one example, operation 1202 may fill the inside of the at least one through hole 512 and/or the slot 513 with the conductive material (or "conductive material") through a hole plugging printing technique, but filling the inside of the at least one through hole 512 with the conductive material is not limited to the above-described embodiment. In another example, the conductive material filling the inside of the at least one through hole 512 and/or the slot 513 may be other material than copper. The conductive material may include, for example, at least one of silver paste, aluminum, silver-aluminum, carbon paste, or CNT paste, but is not limited thereto.

The interposer structure manufacturing operations according to an embodiment may planarize (or "polish") the top surface and/or the bottom surface of the printed circuit board 501 in operation 1203. For example, a region protruding upward and/or downward the printed circuit board 501 may be formed in the process of filling the inside of the at least one through hole 512 and/or the slot 513 with the conductive material in operation 1202. In one example, the region protruding upward and/or downward the printed circuit board 501 may be removed through the planarization process. In one example, the top surface and/or the bottom surface of the printed circuit board 501 may be planarized through the brushing or the buffing in operation 1203. In another example, the top surface and/or the bottom surface of the printed circuit board 501 may be planarized through the polishing in operation 1203. For example, the polishing may include at least one of the mechanical polishing or the CMP.

According to an embodiment, by planarizing the region protruding upward and/or downward the printed circuit board 501 in operation 1203, at least one first conductive via 531 (e.g., the at least one first conductive via 531 of FIG. 11A) and/or at least one second conductive via 532 (e.g., the at least one second conductive via 532 of FIG. 11A) may be formed. As the at least one second conductive via 532 is formed by filling the slot 513 having the greater area than the at least one through hole 512 with the conductive material in operation 1202, the at least one second conductive via 532 may be formed to have a relatively lower height than the at least one first conductive via 531. For example, the at least one first conductive via 531 may be formed to have a first height hi, and the at least one second conductive via 532 may be formed to have a second height h₂ which is lower than the first height hi.

Referring to FIG. 12 and FIG. 13C, the interposer structure manufacturing operations according to an embodiment may remove the copper foil 502 disposed on the top surface and the bottom surface of the insulation layer 510, by etching the top surface and/or the bottom surface of the printed circuit board 501 in operation 1204. In one example, as the at least one first conductive via 531 and/or the at least one second conductive via 532 are formed of other material than copper, the at least one first conductive via 531 and/or the at least one second conductive via 532 may not be removed in etching the top surface and/or the bottom surface of the printed circuit board 501. In another example, as the copper foil 502 disposed on the top surface 510a and the bottom surface 510b of the insulation layer 510 is removed, some region of the at least one first conductive via 531 protruding from the top surface 510a and/or the bottom surface 510b of the insulation layer 510 may be formed. For example, operation 1204 may form a first protruding portion 531a (e.g., the first protruding portion 531 a of FIG. 11C) of the at least one first conductive via 531 protruding from the top surface 510a of the insulation layer 510 in the +z direction and/or a second protruding portion 531b (e.g., the second protruding portion 531b of FIG. 11C) of the at least one first conductive via 531 protruding from the bottom surface 510b of the insulation layer 510 in the -z direction.

Referring to FIG. 12 and FIG. 13D, the interposer structure manufacturing operations according to an embodiment may form a solder resist layer 520 (e.g., the solder resist layer 520 of FIG. 11A) in at least one region of the top surface 510a and/or the bottom surface 510b of the insulation layer 510 in operation 1205. In one example, operation 1205 may form the solder resist layer 520 through a process of applying solder resist ink to regions except for one region of the at least one first conductive via 531 and/or the at least one second conductive via 532 of the top surface 510a and/or the bottom surface 510b of the insulation layer 510, and then curing the spread ink by applying UV ray to the spread ink, but it is not limited thereto. For example, in operation 1205, a first solder resist layer 521 (e.g., the first solder resist layer 521 of FIG. 11A) may be formed on the top surface 510a of the insulation layer 510, and a second solder resist layer 522 (e.g., the second solder resist layer 522 of FIG. 11A) may be formed on the bottom surface 510b of the insulation layer 510.

In one example, as the solder resist ink is applied to the other regions than one region of the at least one first conductive via 531 and/or the at least one second conductive via 532, at least one first opening 521a and/or at least one second opening 521b may be formed in the first solder resist layer 521, and at least one third opening 522a and/or at least one fourth opening 522b may be formed in the second solder resist layer 522. For example, the at least one first opening 521a may be formed in a region corresponding to the at least one first conductive via 531 of the first solder resist layer 521, and the at least one second opening 521b may be formed in a region corresponding to one region of the at least one second conductive via 532. As another example, the at least one third opening 522a may be formed in a region corresponding to the at least one first conductive via 531 of the second solder resist layer 522, and the at least one second opening 522b may be formed in a region corresponding to one region of the at least one second conductive via 532.

Referring to FIG. 12 and FIG. 13E, the interposer structure manufacturing operations according to an embodiment may form a presolder 540 (e.g., the presolder 540 of FIG. 11A) in the at least one first conductive via 531 and/or the at least one second conductive via 532 in operation 1206. In one example, in operation 1206, a first presolder 541 may be formed in the first protruding portion 531a of the at least one first conductive via 531 and/or at least one region of one end (e.g., one end of the +z direction of FIG. 13E) of the at least one second conductive via 532. In another example, a second presolder 542 may be formed in the second protruding portion 531b of the at least one first conductive via 531 and/or at least one region of the other end (e.g., one end of the - z direction of FIG. 13E) of the at least one second conductive via 532.

In one example, the first presolder 541 may be formed through a process (or "reflow process") of applying or squeezing solder cream (or "solder paste") to the first protruding portion 531a and/or one region of the at least one second conductive via 532 exposed to the outside through the at least one first opening 521a and/or the at least one second opening 521b, and then melting the applied solder cream, but it is not limited thereto. In another example, the second presolder 542 may be formed through a process of applying or squeezing solder cream to the second protruding portion 531b and/or one region of the at least one second conductive via 532 exposed to the outside through the at least one third opening 522a and/or the at least one fourth opening 522b, and then melting the applied solder cream, but it is not limited thereto.

The manufacturing operations of the interposer structure according to an embodiment may manufacture the interposer structure 500 not including a land for receiving the presolder 540 in operation 1201 through operation 1206 described above.

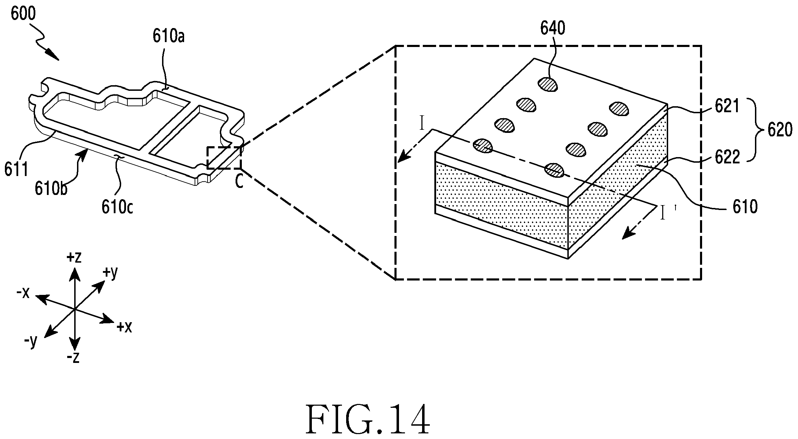

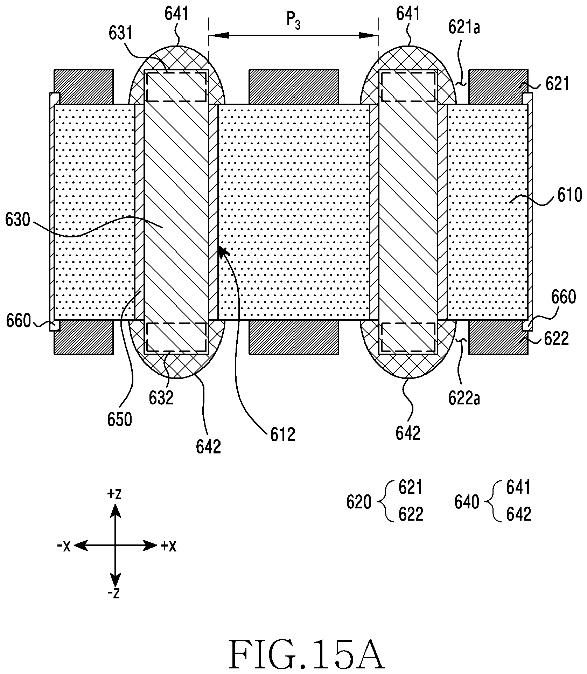

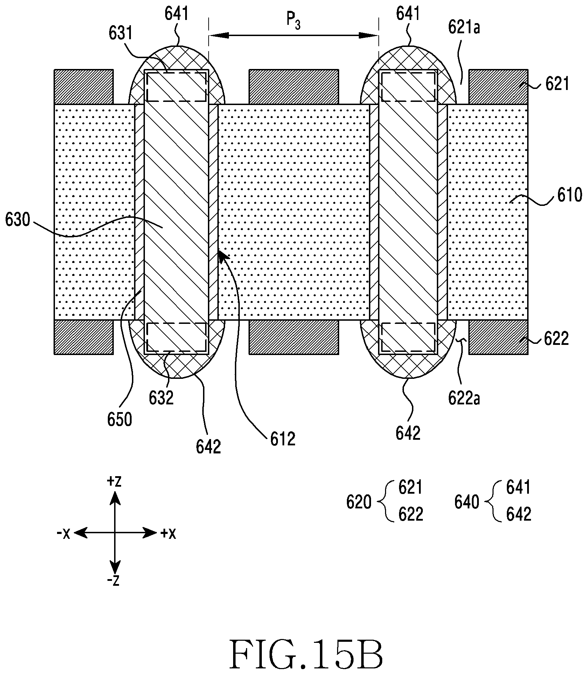

FIG. 14 is an enlarged view of an interposer structure and a region C of the interposer structure according yet to another embodiment, FIG. 15A is a cross-sectional view of the interposer structure of FIG. 14 taken along a I-I' direction, according to an embodiment, and FIG. 15B is a cross-sectional view of the interposer structure of FIG. 14 taken along a I-I' direction, according to another embodiment. An interposer structure 600 shown in FIG. 14 may be one structure of the interposer 340 disposed between the first printed circuit board 331 and the second printed circuit board 332 of FIG. 5.

Referring to FIG. 14, FIG. 15A, and/or FIG. 15B, an interposer structure 600 (or "printed circuit board structure") according to an embodiment may include an insulation layer 610 (e.g., the insulation layer 341 of FIG. 5), at least one layer of solder resist layer (or "solder resist") 620, at least one conductive via 630 (e.g., the at least one conductive via 342 of FIG. 5), a presolder 640 and/or a conductive pad 650. The interposer structure 600 according to an embodiment may be a structure in which the conductive pad 650 is added in the interposer structure 400 of FIG. 6 and/or the interposer structure 500 of FIG. 10.

According to an embodiment, the insulation layer 610 may be formed of a material having a nonconductive material, and may be formed in a closed-curve shape. For example, the insulation layer 610 may be formed in a band shape making a closed curve, when viewed from above (e.g., the +z direction of FIG. 14). In one example, the insulation layer 610 may include at least one side wall 611 forming a closed curve and having a designated thickness and/or at least one through hole 612 (or "via hole") penetrating at least one region of the insulation layer 610. In one example, the at least one side wall 611 may form at least one side surface of the insulation layer 610. In another example, the at least one through hole 612 may be formed in at least one region of an inner region of the insulation layer 610 spaced apart from the side surface of the insulation layer 610. For example, the at least one through hole 612 may be formed by penetrating from one surface toward the +z direction of the insulation layer 610 to the surface toward the -z direction of the insulation layer 610, but is limited thereto.

According to another embodiment (not shown), the insulation layer 610 may further include a slot (not shown) (e.g., the slot 513 of FIG. 10) of a bar shape having designated length and/or thickness penetrating at least one region of the insulation layer 610. The above-described slot may be substantially identical or similar to the slot 513 of FIG. 10, and redundant descriptions thereof shall be omitted hereafter.

According to an embodiment, the at least one solder resist layer 620 may be disposed on at least one region of a top surface 610a and/or a bottom surface 610b of the insulation layer 610. For example, the at least one solder resist layer 620 may prevent leader from joining to one region of the insulation layer 610 on which the at least one solder resist layer 620 is disposed in soldering (or "soldering") an electronic component (e.g., the first printed circuit board 331, the second printed circuit board 332 of FIG. 5) on and/or below the interposer structure 600.

According to an embodiment, the at least one solder resist layer 620 may include a first solder resist layer 621 and/or a second solder resist layer 622. In one example, the first solder resist layer 621 may be disposed on at least one region of the top surface 610a of the insulation layer 610, to prevent lead from joining to the top surface 610a of the insulation layer 610. In another example, the second solder resist layer 622 may be disposed on at least one region of the bottom surface 610b of the insulation layer 610, to prevent lead from joining to the bottom surface 610b of the insulation layer 610.

In one example, the first solder resist layer 621 may include at least one first opening 621a formed at a position corresponding to the at least one through hole 612 of the insulation layer 610. For example, when viewed from above the interposer structure 600 (e.g., the +z direction of FIG. 15A, FIG. 15B), at least one region of the at least one first opening 621a may be disposed to overlap the at least one through hole 612. As another example, the at least one first opening 621a may be formed in a greater area than the at least one through hole 612, and accordingly an outer circumferential surface of the at least one first opening 621a may surround an outer circumferential surface of the at least one through hole 612. The shape of the at least one first opening 621a is not limited to the above-described embodiment, and the at least one first opening 621a may be formed in a narrow area than the at least one through hole 612, or may be formed in substantially the same area according to another embodiment (not shown).

In one example, the second solder resist layer 622 may include at least one second opening 622a formed at a position corresponding to the at least one through hole 612 of the insulation layer 610. For example, when viewed from below the interposer structure 600 (e.g., the -z direction of FIG. 15A, FIG. 15B), at least one region of the at least one second opening 622a may be disposed to overlap the at least one through hole 612. As another example, the at least one second opening 622a may be formed in a greater area than the at least one through hole 612, and an outer circumferential surface of the at least one second opening 622a may surround the outer circumferential surface of the at least one through hole 612. The shape of the at least one second opening 622a is not limited to the above-described embodiment, and the at least one second opening 622a may be formed in a narrow area than the at least one through hole 612, or may be formed in substantially the same area according to another embodiment (not shown).

As another example, the at least one second opening 622a may be formed at a position corresponding to the at least one first opening 621a of the first solder resist layer 621. In one example, some region of the insulation layer 610 and/or some region of the at least one conductive via 630 may be exposed to the outside of the interposer structure 600 through the at least one first opening 621a formed in the first solder resist layer 621 and/or the at least one second opening 622a formed in the second solder resist layer 622.

According to an embodiment, the at least one conductive via 630 may be positioned inside the at least one through hole 612 of the insulation layer 610. The at least one conductive via 630 may be formed of a conductive material (e.g., metal), to electrically connect electronic components disposed in the interposer structure 600. For example, the at least one conductive via 630 may electrically connect an electronic component (e.g., the first printed circuit board 331 of FIG. 5) disposed below (e.g., the -z direction of FIG. 14) of the interposer structure 600 and an electronic component (e.g., the second printed circuit board 332 of FIG. 5) disposed on (e.g., the +z direction of FIG. 14) of the interposer structure 600. As another example, the at least one conductive via 630 may include a cylindrical (or "hole-shaped") conductive via (e.g., the at least one first conductive via 531 of FIG. 11D), but is not limited thereto. According to another embodiment (not shown), the at least one conductive via 630 may include a conductive via (e.g., the at least one second conductive via 532 of FIG. 11D) positioned inside the slot, and of a rectangular bar shape having designated length and/or thickness.

In one example, the at least one conductive via 630 may include a first protruding portion 631 protruding the top surface 610a of the insulation layer 610 in a direction (e.g., the +z direction of FIG. 15A, FIG. 15B) in which the at least one first opening 621a of the first solder resist layer 621 is formed and/or a second protruding portion 632 protruding from the bottom surface 610b of the insulation layer 610 in a direction (e.g., the -z direction of FIG. 15A, FIG. 15B) in which the at least one second opening 622a of the second solder resist layer 622 is formed. For example, the first protruding portion 631 of the at least one conductive via 630 may protrude from the top surface 610a of the insulation layer 610 to one surface toward the +z direction of the first solder resist layer 621. As another example, the second protruding portion 632 of the at least one conductive via 630 may protrude from the bottom surface 610b of the insulation layer 610 to one surface toward the -z direction of the second solder resist layer 622.

According to an embodiment, the conductive pad 650 may be positioned inside the at least one through hole 612 of the insulation layer 610, to surround the outer circumferential surface of the at least one conductive via 630. In one example, the conductive pad 650 may be formed by plating the inside of the at least one through hole 612. In another example, the conductive pad 650 may be positioned between the inner side of the at least one through hole 612 and the outer circumferential surface of the at least one conductive via 630, to firmly secure the at least one conductive via 630 to the insulation layer 610.

According to an embodiment, the presolder 640 may be positioned in a top region (e.g., a region of the +z direction of FIG. 15A, FIG. 15B) and/or a bottom region (e.g., a region of the - z direction of FIG. 15A, FIG. 15B) of the interposer structure 600, to secure the electronic component disposed on and/or below the interposer structure 600 to the interposer structure 600.

In an embodiment, the presolder 640 may include a first presolder 641 and/or a second presolder 642. In one example, the first presolder 641 may be disposed on the first protruding portion 631 of the at least one conductive via 630 exposed to the outside of the interposer structure 600 through the at least one first opening 621a of the first solder resist layer 621. For example, the first presolder 641 may be received at one end of the first protruding portion 631 (e.g., one end of the +z direction of FIG. 15A, FIG. 15B). In another example, the second presolder 642 may be disposed on the second protruding portion 632 of the at least one conductive via 630 exposed to the outside of the interposer structure 600 through the at least one second opening 622a of the second solder resist layer 622. For example, the second presolder 642 may be received at one end of the second protruding portion 632 (e.g., one end of the -z direction of FIG. 15A, FIG. 15B).

According to an embodiment, the interposer structure 600 may fix electronic components to the top and/or the bottom of the interposer structure 600 through the first presolder 641 and/or the second presolder 642. For example, the interposer structure 600 may solder a second printed circuit board (e.g., the second printed circuit board 332 of FIG. 5) to the top (e.g., the +z direction of FIG. 15A, FIG. 15B) of the interposer structure 600 by applying heat to the first presolder 641. As another example, the interposer structure 600 may solder a first printed circuit board (e.g., the first printed circuit board 331 of FIG. 5) to the bottom (e.g., the -z direction of FIG. 15A, FIG. 15B) of the interposer structure 600 by applying heat to the second presolder 642.

According to an embodiment, the interposer structure 600 may form a space for receiving the presolder 640, without forming a land through the at least one conductive via 630 including the first protruding portion 631 and/or the second protruding portion 632 protruding upward and/or downward based on the insulation layer 610. In one example, as the interposer structure 600 is formed in the landless structure not including the land, a pitch P₃ between the conductive vias 630 may not be spaced over a designated pitch to secure the space for the land. For example, the above-described interposer structure 600 having the landless structure may form a shorter pitch between the conductive vias 630 than the interposer structure including the land. According to an embodiment, by forming the smaller pitch P₃ between the conductive vias 630, the interposer structure 600 may densely arrange or mount electronic components on a plurality of printed circuit boards (e.g., the first printed circuit board 331, the second printed circuit board 332 of FIG. 5) disposed on and/or below the interposer structure 600.

Referring to FIG. 15A, according to an embodiment, the interposer structure 600 may further include a side plating portion 660. In one example, the side plating portion 660 may be positioned in at least one region of the side surface 610c of the insulation layer 610, to electromagnetically shield the interposer structure 600. In the present disclosure, the side surface 610c of the insulation layer 610 may indicate a surface positioned between the top surface 610a and the bottom surface 610b of the insulation layer 610, and surrounding the space between the top surface 610a and the bottom surface 610b. For example, the side plating portion 660 may shield noise generated inside the interposer structure 600 (e.g., noise generated from the electronic components) from leaking to the outside of the interposer structure 600, or may shield noise introduced from the outside of the interposer structure 600.

Referring to FIG. 15B, according to another embodiment, the interposer structure 600 may not include the side plating portion for electromagnetically shielding the interposer structure 600. In one example, the at least one conductive via 630 may include a bar-shaped conductive via (e.g., the at least one second conductive via 532 of FIG. 11D), and the bar-shaped conductive via may be formed to have designated length and/or thickness to serve as the ground. The interposer structure 600 according to another embodiment may electromagnetically shield the interposer structure 600, without including a separate side plating portion by means of the bar-shaped conductive via serving as the ground.

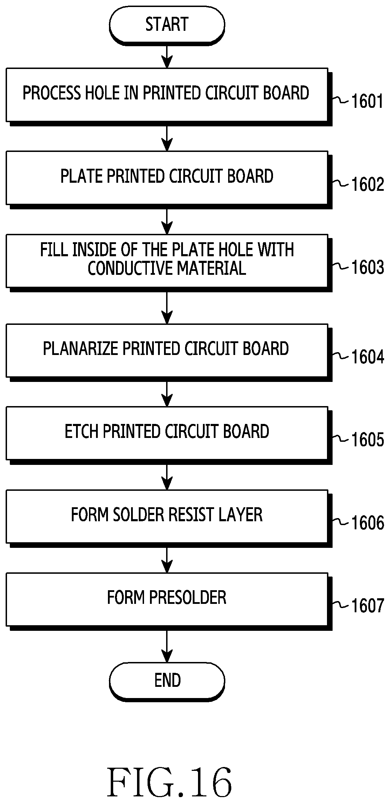

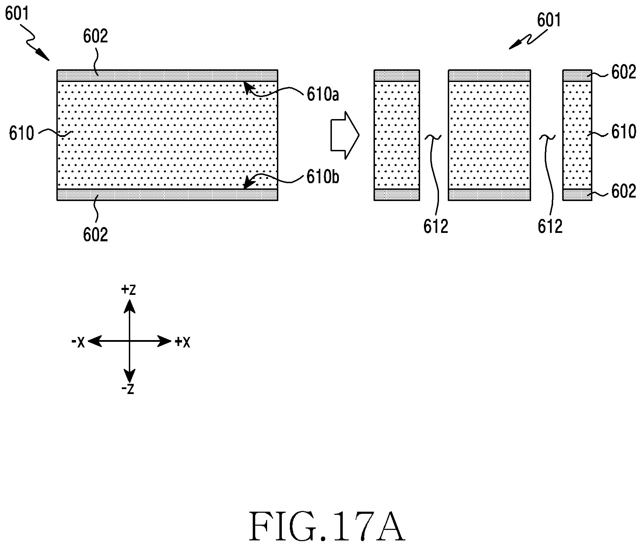

Hereinafter, manufacturing of the interposer structure 600 according to an embodiment will be described, with reference to FIG. 16 and FIG. 17A through FIG. 17F.

FIG. 16 is a flowchart illustrating manufacturing operations of an interposer structure according to yet another embodiment.

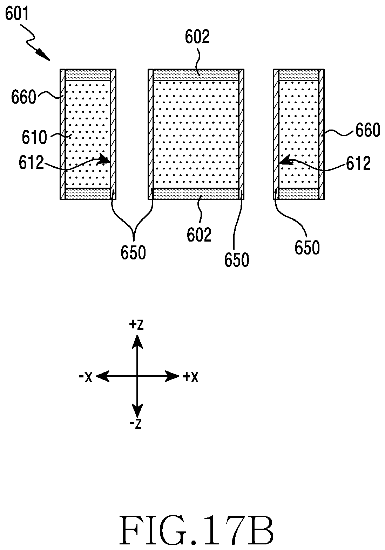

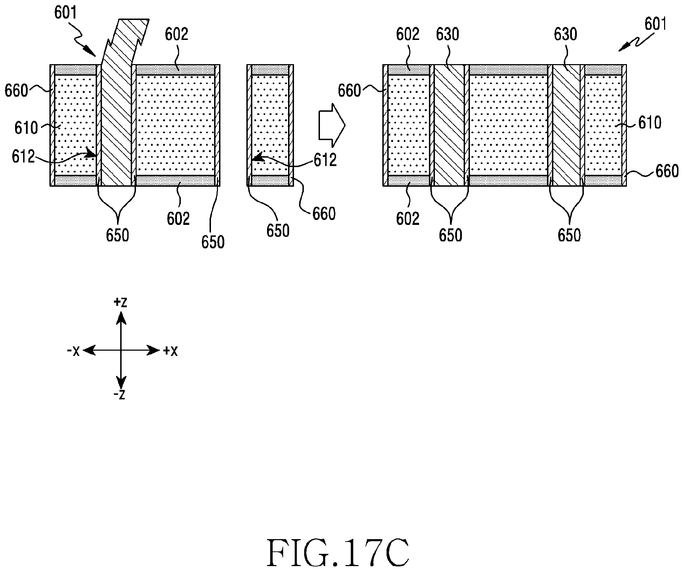

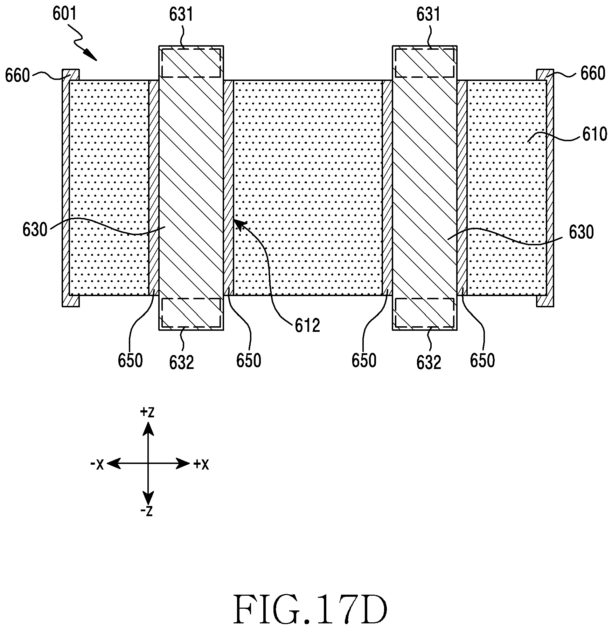

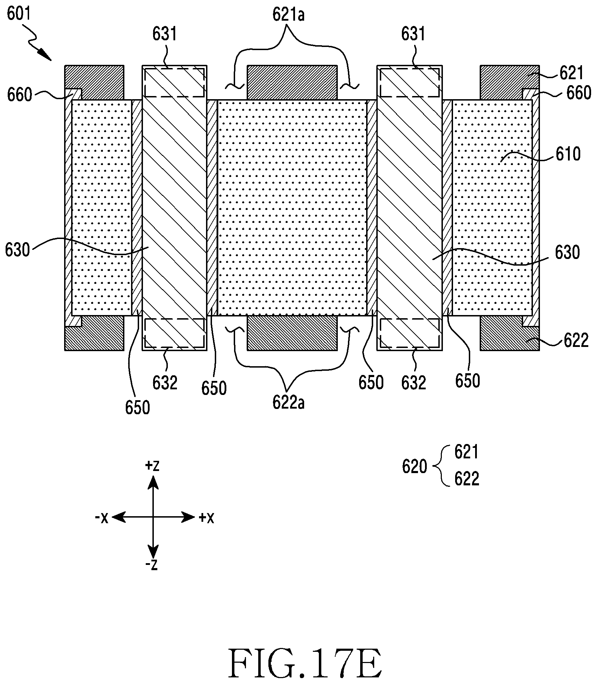

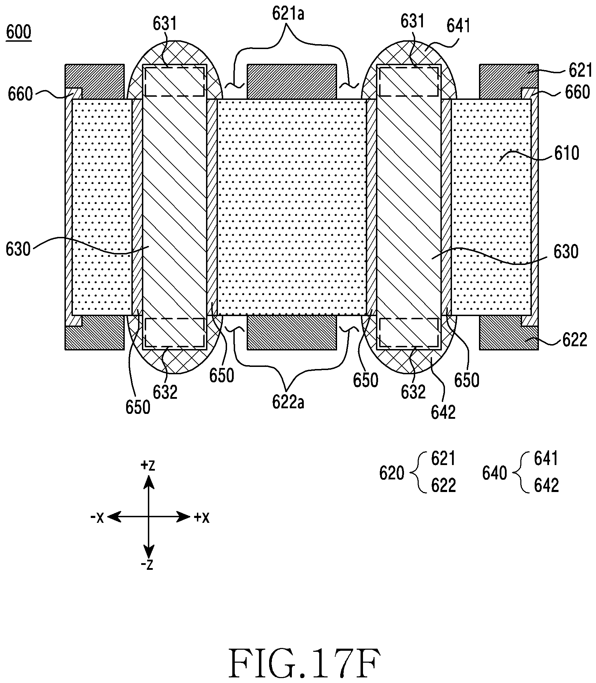

FIG. 17A is a diagram for explaining an operation of forming at least one through hole in a printed circuit board, according to an embodiment, and FIG. 17B is a diagram for explaining an operation of plating an inside of at least one through hole and/or a side surface of an insulation layer, according to an embodiment. FIG. 17C is a diagram for explaining an operation of filling an inside of the at least one through hole with a conductive material, and planarizing the printed circuit board, according to an embodiment. FIG. 17D is a diagram for explaining an operation of etching the printed circuit board, according to an embodiment. FIG. 17E is a diagram for explaining an operation of forming a solder resist layer onto and/or below the printed circuit board, according to an embodiment. FIG. 17F is a diagram for explaining an operation of forming a presolder, according to an embodiment.

FIG. 17A through FIG. 17E show manufacturing operations for some region (e.g., the region C of FIG. 14) of the interposer structure (or "printed circuit board structure"), and other regions of the interposer structure may be manufactured through the same operations. Hereinafter, the manufacturing operations of the interposer structure of FIG. 16 shall be described with reference to the configurations of FIG. 17A through FIG. 17E.

Referring to FIG. 16 and 17A, the manufacturing operations of the interposer structure according to an embodiment, may form at least one through hole 612 (or "via hole") (e.g., the at least one through hole 612 of FIG. 7) which penetrates at least one region of a printed circuit board 601, by processing the printed circuit board 601 in operation 1601. For example, the printed circuit board 601 may include an insulation layer 610 (e.g., the insulation layer 610 of FIG. 14) and/or a copper foil 602 (or "copper clad") disposed on a top surface 610a (e.g., the top surface 610a of FIG. 14) and a bottom surface 610b (e.g., the bottom surface 610b of FIG. 14) of the insulation layer 610, and the at least one through hole 612 may pass through at least one region of the insulation layer 610 and the copper foil 602. According to an embodiment, the at least one through hole 612 may be formed by drilling at least one region of the printed circuit board 601. Notably, the drilling is merely an example of processing for forming the at least one through hole 612, and the at least one through hole 612 may be formed through the laser processing or the punching, according to another embodiment. According to another embodiment, the manufacturing operations of the interposer structure may form the at least one through hole 612 and/or a slot (e.g., the slot 513 of FIG. 11D) in operation 1601. In one example, the slot may be formed to have a greater area than the at least one through hole 612. In another example, the slot may be formed in a substantially identical or similar manner to the processing of forming the at least one through hole 612. For example, the slot may be formed through at least one of a plurality of drilling processing, a plurality of punching processing, or a plurality of laser processing, but is not limited thereto.

Referring to FIG. 16 and FIG. 17B, the interposer structure manufacturing operations the according to an embodiment may plate at least one region of the printed circuit board 601 in operation 1602. In one example, operation 1602 may plate the inside of the at least one through hole 612 of the printed circuit board 601 and/or at least one region of a side surface of the printed circuit board 601. Through operation 1602 described above, a conductive pad 650 (e.g., the conductive pad 650 of FIG. 15A. FIG. 15B) positioned inside the at least one through hole 612 and/or a side plating portion 660 (e.g., the side plating portion 660 of FIG. 15A) may be formed. Forming the side plating portion 660 may include, for example, plating the side surface of the insulation layer 610, and then attaching a dry film to at least one region of the side surface of the insulation layer 610 where the side plating portion is to be formed. In another example, by exposing, developing, and etching at least one region of the side surface of the insulation layer 610 to which the dry film is attached, and then peeling the dry film attached to the insulation layer 610, the side plating portion 660 may be formed in at least one region of the side surface of the insulation layer 610. In another example, operation 1602 may not form the side plating portion 660, by plating only the inside of the at least one through hole 612 of the printed circuit board 601.

Referring to FIG. 16 and FIG. 17C, the interposer structure manufacturing operations according to an embodiment may fill the inside of the at least one through hole 612 formed in the printed circuit board 601 with a conductive material (or "conductive material") in operation 1603. In one example, operation 1603 may fill the inside of the at least one through hole 612 with the conductive material through a hole plugging printing technique, but filling the inside of the at least one through hole 612 with the conductive material is not limited to the above-described embodiment. In another example, the conductive material filling the inside of the at least one through hole 612 may be other material than copper. The conductive material may include, for example, at least one of silver paste, aluminum, silver-aluminum, carbon paste, or CNT paste, but is not limited thereto. Although not depicted in the drawings, operation 1603 may fill the inside of the slot with a conductive material.

The interposer structure manufacturing operations according to an embodiment may planarize (or "polish") a top surface and/or a bottom surface of the printed circuit board 601 in operation 1604. For example, a region protruding toward and/or downward the printed circuit board 601 may be formed in filling the inside of the at least one through hole 612 with the conductive material in operation 1306. The interposer structure manufacturing operation according to an embodiment, may form at least one conductive via 630 (e.g., the conductive vias 630 of FIG. 15A, FIG. 15B), by planarizing the region protruding toward and/or downward the printed circuit board 601 in operation 1604. In an example, operation 1604 may planarize the top surface and/or the bottom surface of the printed circuit board 601 through the brushing or the buffing. In another example, operation 1604 may planarize the top surface and/or the bottom surface of the printed circuit board 601 through the polishing. For example, the polishing process may include at least one of the mechanical polishing or the CMP.

Referring to FIG. 16 and FIG. 17D, the interposer structure manufacturing operations according to an embodiment may remove the copper foil 602 disposed on the top surface and the bottom surface of the insulation layer 610, by etching the top surface and/or the bottom surface of the printed circuit board 601 in operation 1605. In one example, since the at least one conductive via 630 is formed of other material than copper, the at least one conductive via 630 may not be removed in the process of etching the top surface and/or the bottom surface of the printed circuit board 601. In another example, as the copper foil 602 disposed on the top surface 610a and the bottom surface 610b of the insulation layer 610 is removed, some region of the at least one conductive via 630 protruding from the top surface 610a and/or the bottom surface 610b of the insulation layer 610 may be formed. For example, operation 1605 may form a first protruding portion 631 (e.g., the first protruding portion 631 of FIG. 15A, FIG. 15B) of the at least one conductive via 630 protruding from the top surface 610a of the insulation layer 610 in the +z direction and/or a second protruding portion 632 (e.g., the second protruding portion 632 of FIG. 15A, FIG. 15B) of the at least one conductive via 630 protruding from the bottom surface 610b of the insulation layer 610 in the -z direction.

Referring to FIG. 16 and FIG. 17E, the interposer structure manufacturing operations according to an embodiment may form a solder resist layer 620 (e.g., the solder resist layer 620 of FIG. 15A, FIG. 15B) in at least one region of the top surface 610a and/or the bottom surface 610b of the insulation layer 610 in operation 1606. In one example, operation 1606 may form the solder resist layer 620 through a process of spreading solder resist ink to other regions than the region in which the at least one conductive via 630 of the top surface 610a and/or the bottom surface 610b of the insulation layer 610 is disposed, and then curing the spread ink by applying the UV ray to the spread ink, but is not limited thereto. For example, a first solder resist layer 621 (e.g., the first solder resist layer 621 of FIG. 15A, FIG. 15B) may be formed on the top surface 610a of the insulation layer 610, and a second solder resist layer 622 (e.g., the second solder resist layer 422 of FIG. 15A, FIG. 15B) may be formed on the bottom surface 610b of the insulation layer 610 in operation 1605. As another example, as the solder resist ink is applied to the other regions than the region in which the conductive via 630 is disposed, at least one first opening 621a (e.g., the at least one first opening 621a of FIG. 15A, FIG. 15B) may be formed in the region corresponding to the at least one conductive via 630 of the first solder resist layer 621. Similarly, at least one second opening 622a (e.g., the at least one second opening 622a of FIG. 15A, FIG. 15B) may be formed in the region corresponding to the at least one conductive via 630 of the second solder resist layer 622.

Referring to FIG. 16 and FIG. 17F, the interposer structure manufacturing operations according to an embodiment may form a presolder 640 (e.g., the presolder 640 of FIG. 14) in the first protruding portion 631 and/or the second protruding portion 632 of the at least one conductive via 630 in operation 1607. In one example, a first presolder 641 may be formed in at least one region of the first protruding portion 631 of the at least one conductive via 630, and a second presolder 642 may be formed in at least one region of the second protruding portion 632 of the at least one conductive via 630 in operation 1607. The first presolder 641 and/or the second presolder 642 may be formed through a process (or "reflow process") of applying or squeezing solder cream (or "solder paste") to the first protruding portion 631 and/or the second protruding portion 632 using, for example, a metal mask, and then melting the applied solder cream, but it is not limited thereto. The manufacturing operations of the interposer structure according to an embodiment may manufacture the interposer structure 600 not including a land for receiving the presolder 640 in operation 1601 through operation 1607 described above.

The interposer structure 400, 500, and 600 of the present disclosure may include an insulation layer 341, 410, 510, and 610, a first solder resist layer 421, 521, and 621, a second solder resist layer 422, 522, and 622, at least one conductive via 342, 430, and 630, a first presolder 441, 541, and 641 and a second presolder 442, 542, 642. The insulation layer 341, 410, 510, and 610 may include at least one through hole. The first solder resist layer 421, 521, and 621 may be positioned in at least one region of a top surface of the insulation layer 341, 410, 510, and 610, and include one first opening 421a, 521a, and 621a formed in a region corresponding to the at least one through hole. The second solder resist layer 422, 522, and 622 may be positioned in at least one region of a bottom surface of the insulation layer 341, 410, 510, and 610, and may include at least one second opening 422, 521b, 522b, and 622a formed in a region corresponding to the at least one through hole. The at least one conductive via 342, 430, and 630 may be positioned in the at least one through hole. The at least one conductive via 342, 430, and 630 may include a first protruding portion 431, 531a and 631 formed by protruding toward the at least one first opening 421a, 521a, and 621a and a second protruding portion 432, 531b and 632 formed by protruding toward the at least one second opening 422, 521b, 522b and 622a. The first presolder 441, 541, and 641 may be disposed at a top of the first protruding portion 431, 531a, and 631 of the at least one conductive via 342, 430, and 630. The second presolder 442, 542, and 642 may be disposed at a bottom of the second protruding portion 432, 531b and 632 of the at least one conductive via 342, 430, and 630.

The first protruding portion 431, 531a, and 631 of the interposer structure 400, 500, and 600 of the present disclosure may be formed to protrude from the top surface of the insulation layer 341, 410, 510 and 610 to the first solder resist layer 421, 521, and 621.

The second protruding portion 432, 531b, and 632 of the interposer structure 400, 500 and 600 of the present disclosure may be formed to protrude from the bottom surface of the insulation layer 341, 410, 510 and 610 to the second solder resist layer 422, 522, and 622.

The interposer structure 400, 500, and 600 of the present disclosure may further include a conductive pad 650 positioned inside the at least one through hole, and disposed to surround an outer circumferential surface of the at least one conductive via 342, 430, 630.

The interposer structure 400, 500, and 600 of the present disclosure may further include a side plating portion 450 and 660 positioned in at least one region of a side surface of the insulation layer 341, 410, 510, and 610, and electromagnetically shielding the interposer structure 400, 500, and 600.

The at least one conductive via 342, 430, and 630 of the interposer structure 400, 500, and 600 of the present disclosure may be formed in a cylindrical shape.

The interposer structure 400, 500 and 600 of the present disclosure may further include a first printed circuit board 331 disposed at a top of the interposer structure 400, 500 and 600 and a second printed circuit board 332 disposed at a bottom of the interposer structure 400, 500 and 600. The first printed circuit board 331 may be electrically connected to the second printed circuit board 332 through the at least one conductive via 342, 430, and 630.

The first printed circuit board 331 of the interposer structure 400, 500, and 600 of the present disclosure may be fixed to the top of the interposer structure 400, 500, and 600 through the first presolder 441, 541, and 641.

The second printed circuit board 332 of the interposer structure 400, 500, and 600 of the present disclosure may be fixed to the bottom to the interposer structure 400, 500, and 600 through the second presolder 442, 542, and 642.

The insulation layer 341, 410, 510, and 610 of the interposer structure 400, 500 and 600 of the present disclosure may be formed in a band shape formed along at least one edge of the first printed circuit board 331 or the second printed circuit board 332, when viewed from above the interposer structure 400, 500 and 600.

The interposer structure 400, 500, and 600 of the present disclosure may include an insulation layer 341, 410, 510, and 610, a first solder resist layer 421, 521, and 621, a second solder resist layer 422, 522, and 622, a first conductive via 530 and 531, a second conductive via 532, a first presolder 441, 541, and 641 and a second presolder 442, 542, and 642. The insulation layer 341, 410, 510, and 610 may include at least one through hole and a slot. The first solder resist layer 421, 521, and 621 may be positioned in at least one region of a top surface of the insulation layer 341, 410, 510, and 610, and may include a first opening 421a, 521a, and 621a formed in a region corresponding to the at least one through hole and at least one second opening 422, 521b, 522b, and 622a formed in a region corresponding to at least one region of the slot. The second solder resist layer 422, 522, and 622 may be positioned in at least one region of the bottom surface of the insulation layer 341, 410, 510, and 610, and may include at least one third opening formed in a region corresponding to the at least one through hole and at least one fourth opening formed in a region corresponding to at least one region of the slot. The first conductive via 530 and 531 may be positioned in the at least one through hole, and formed to have a first height. The first conductive via 530 and 531 include a first protrusion portion 431, 531a, and 631 formed to protrude toward the at least one first opening 421a, 521a, 621a, and a second protruding portion 432, 531b, and 632 formed to protrude toward the at least one third opening. The second conductive via 532 may be positioned in the slot, and formed to have a second height lower than the first height. The first presolder 441, 541, and 641 may be disposed at upper ends of the first conductive via 530 and 531 and the second conductive via 532. The second presolder 442, 542, and 642 may be disposed at lower ends of the first conductive via 530 and 531 and the second conductive via 532.

The first conductive via 530 and 531 of the interposer structure 400, 500, and 600 of the present disclosure may be formed in a cylindrical shape.

The second conductive via 532 of the interposer structure 400, 500, and 600 of the present disclosure may be formed in a bar shape having a designated length, when viewed from above the interposer structure 400, 500, and 600.

The second conductive via 532 of the interposer structure 400, 500, and 600 of the present disclosure may serve as a ground for electromagnetically shielding the interposer structure 400, 500, and 600.

The second conductive via 532 of the interposer structure 400, 500, and 600 of the present disclosure may be formed at same height as the insulation layer 341, 410, 510, and 610.

The first protruding portion 431, 531a, and 631 of the first conductive via 530 and 531 of the interposer structure 400, 500, and 600 of the present disclosure may be formed to protrude from the top surface of the insulation layer 341, 410, 510, and 610 to the first solder resist layer 421, 521, 621.

The second protruding portion 432, 531b and 632 of the first conductive via 530 and 531 of the interposer structure 400, 500, and 600 of the present disclosure may be formed to protrude from the bottom surface of the insulation layer 341, 410, 510, and 610 to the second solder resist layer 422, 522, and 622.

The interposer structure 400, 500, and 600 of the present disclosure may further include a first conductive pad 650 and a second conductive pad 650. The first conductive pad 650 may be positioned inside the at least one through hole, and disposed to surround an outer circumferential surface of the first conductive via 530 and 531. The second conductive pad 650 may be positioned inside the slot, and disposed to surround an outer circumferential surface of the second conductive via 532.

The interposer structure 400, 500, and 600 of the present disclosure may include a first printed circuit board 331, a second printed circuit board 332, an electronic component, and an interposer. The second printed circuit board 332 may be spaced apart from the first printed circuit board 331 to face at least one surface of the first printed circuit board 331. The electronic component may be disposed on the first printed circuit board 331 or the second printed circuit board 332. The interposer may be positioned between the first printed circuit board 331 and the second printed circuit board 332, and disposed to surround a space between the first printed circuit board 331 and the second printed circuit board 332. The interposer may include an insulation layer 341, 410, 510, and 610, a first solder resist layer 421, 521, 621, a second solder resist layer 422, 522, 622, and a first conductive via 530 and 531. The insulation layer 341, 410, 510, and 610 may include a first surface facing the first printed circuit board 331, and a second surface facing the second printed circuit board 332, and may include at least one through hole formed by penetrating the first surface and the second surface. The first solder resist layer 421, 521, and 621 may be disposed in at least one region of the first surface of the insulation layer 341, 410, 510, and 610, and include a first opening 421a, 521a, and 621a formed in a region corresponding to the at least one through hole. The second solder resist layer 422, 522, and 622 may be disposed in at least one region of the second surface of the insulation layer 341, 410, 510, and 610, and may include a second opening 422, 521b, 522b, and 622a formed in a region corresponding to the at least one through hole. The first conductive via 530 and 531 may be positioned inside the at least one through hole, and may include a first protruding portion 431, 531a, and 631 formed to protrude from the first surface of the insulation layer 341, 410, 510, and 610 to the first solder resist layer 421, 521, and 621 and a second protruding portion 432, 531b, and 632 formed to protrude from the second surface of the insulation layer 341, 410, 510, and 610 to the second solder resist layer 422, 522, and 622. The first printed circuit board 331 may be electrically connected to the second printed circuit board 332 through the first conductive via 530 and 531.

The interposer of the interposer structure 400, 500, 600 of the present disclosure may further include a slot penetrating the first surface and the second surface of the insulation layer 341, 410, 510 and 610 and a second conductive via 532 positioned inside the slot and electrically connecting the first printed circuit board 331 and the second printed circuit board 332.

The first conductive via 530 and 531 of the interposer structure 400, 500, and 600 of the present disclosure may be formed in a cylindrical shape. The second conductive via 532 may be formed in a bar shape having a designated length, when viewed from above the interposer.

The second conductive via 532 of the interposer structure 400, 500, and 600 of the present disclosure may serve as a ground for electromagnetically shielding the at least one electronic component.

In the specific embodiments of the present disclosure, the components included in the disclosure are expressed in a singular or plural form. However, the singular or plural expression is appropriately selected according to a proposed situation for the convenience of explanation, the present disclosure is not limited to a single component or a plurality of components, the components expressed in the plural form may be configured as a single component, and the components expressed in the singular form may be configured as a plurality of components.

Meanwhile, while the specific embodiment has been described in the detailed explanations of the present disclosure, it will be noted that various changes may be made therein without departing from the scope of the present disclosure. Therefore, the scope of the present disclosure should not be limited to the described embodiments and should be defined by the claims described below as well as the claims and their equivalents.

## Claims

1. An interposer structure comprising:
an insulation layer comprising at least one through hole;
a first solder resist layer positioned on at least one region of a top surface of the insulation layer, and comprising at least one first opening formed in a region corresponding to the at least one through hole;
a second solder resist layer positioned on at least one region of a bottom surface of the insulation layer, and comprising at least one second opening formed in a region corresponding to the at least one through hole;
at least one conductive via positioned in the at least one through hole, the at least one conductive via comprising a first protruding portion which protrudes in a direction of the at least one first opening and a second protruding portion which protrudes in a direction of the at least one second opening;
a first presolder disposed at an upper end of the first protruding portion of the at least one conductive via; and
a second presolder disposed at a lower end of the second protruding portion of the at least one conductive via.

2. The interposer structure of claim 1, wherein the first protruding portion is formed by protruding from the top surface of the insulation layer to the first solder resist layer.

3. The interposer structure of claim 2, wherein the second protruding portion is formed by protruding from the bottom surface of the insulation layer to the second solder resist layer.

4. The interposer structure of claim 1, further comprising:
a conductive pad positioned inside the at least one through hole, and disposed to surround an outer circumferential surface of the at least one conductive via.

5. The interposer structure of claim 1, further comprising:
a side plating portion positioned in at least one region of a side surface of the insulation layer, and electromagnetically shielding the interposer structure.

6. The interposer structure of claim 1, wherein the at least one conductive via is formed in a cylindrical shape.

7. The interposer structure of claim 1, further comprising:
a first printed circuit board disposed at a top of the interposer structure; and
a second printed circuit board disposed at a bottom of the interposer structure,
wherein the first printed circuit board is electrically connected with the second printed circuit board through the at least one conductive via.

8. The interposer structure of claim 7, wherein the first printed circuit board is fixed to a top of the interposer structure through the first presolder, and
the second printed circuit board is fixed to a bottom of the interposer structure through the second presolder.

9. The interposer structure of claim 7, wherein the insulation layer is formed in a band shape formed along at least one edge of the first printed circuit board or the second printed circuit board, when viewed from above of the interposer structure.
